# EUROPÄISCHE PATENTSCHRIFT

(11) **EP 1 646 674 B1**
(45) Veröffentlichungstag und Bekanntmachung des Hinweises auf die Patenterteilung: **24.01.2007**
(21) Anmeldenummer: 04740851.3
(22) Anmeldetag: 09.07.2004
(51) Int. Cl.: C08G 73/18, C08G 73/22, H01M 8/10

(54) **ASYMMETRISCHE POLYMERFOLIE, VERFAHREN ZU DEREN HERSTELLUNG SOWIE DEREN VERWENDUNG**
ASYMMETRIC POLYMER FILM, METHOD FOR THE PRODUCTION AND THE UTILIZATION THEREOF
FEUILLE POLYMERE ASYMETRIQUE, PROCEDES DE FABRICATION ET UTILISATION ASSOCIES

(30) Priorität: 11.07.2003 DE 10331365
(43) Veröffentlichungstag der Anmeldung: 19.04.2006
(73) Patentinhaber: Pemeas GmbH, 65926 Frankfurt am Main (DE)
(72) Erfinder: PETERSEN, Joachim, 36039 Fulda (DE); BAURMEISTER, Jochen, 65817 Eppstein (DE); UENSAL, Oemer, 55128 Mainz (DE); KIEFER, Joachim, 66679 Losheim am See (DE)
(74) Vertreter: Luderschmidt, Schüler & Partner
(86) Internationale Anmeldenummer: PCT/EP2004/007570
(87) Internationale Veröffentlichungsnummer: WO 2005/007725

(56) Entgegenhaltungen:
- EP-A- 0 141 793
- WO-A-02/04083
- US-A- 4 272 353

## Beschreibung

Die vorliegende Erfindung betrifft eine mit asymmetrische Polymerfolie, insbesondere auf Basis von Polyazolen, ein Verfahren zur Herstellung derselben sowie ihre Verwendung.

Die erfindungsgemäße Polymerfolie kann aufgrund ihrer hervorragenden chemischen, thermischen und mechanischen Eigenschaften vielfältig eingesetzt werden und eignet sich insbesondere als Polymer-Elektrolyt-Membran (PEM) in sogenannten PEM-Brennstoffzellen.

Um für den Einsatz in PEM-Brennstoffzellen geeignet zu sein müßen die Polyazolmembranen mit Säure dotiert werden. Hierfür werden die basischen Polyazol-Membranen mit konzentrierter Phosphorsäure oder Schwefelsäure behandelt und wirken als Protonenleiter und Separatoren in sogenannten Polymerelektrolyt-Membran-Brennstoffzellen (PEM-Brennstoffzellen).

Bedingt durch die hervorragenden Eigenschaften des Polyazol-Polymeren können derartige Polymerelektrolytmembran - zu Membran-Elektroden-Einheit (MEE) verarbeitet - bei Dauerbetriebstemperaturen oberhalb 100°C insbesondere oberhalb 120°C in Brennstoffzellen eingesetzt werden. Diese hohe Dauerbetriebstemperatur erlaubt es die Aktivität der in der Membran-Elektroden-Einheit (MEE) enthaltenen Katalysatoren auf Edelmetallbasis zu erhöhen. Insbesondere bei der Verwendung von sogenannten Reformaten aus Kohlenwasserstoffen sind im Reformergas deutliche Mengen an Kohlenmonoxid enthalten, die überlicherweise durch eine aufwendige Gasaufbereitung bzw. Gasreinigung entfernt werden müssen. Durch die Möglichkeit die Betriebstemperatur zu erhöhen, können deutlich höhere Konzentrationen an CO-Verunreinigungen dauerhaft toleriert werden.

Durch Einsatz von Polymer-Elektrolyt-Membranen auf Basis von Polyazol-Polymeren kann zum einen auf die aufwendige Gasaufbereitung bzw. Gasreinigung teilweise verzichtet werden und andererseits die Katalysatorbeladung in der Membran-Elektroden-Einheit reduziert werden. Beides ist für einen Masseneinsatz von PEM-Brennstoffzellen unabdingbare Voraussetzung, da ansonsten die Kosten für ein PEM-Brennstoffzellen-System zu hoch sind.

Die Dotierung von Polymermembranen mit starken Säuren ist oft mit einem erheblichen Aufwand verbunden, da die Aufnahme der Säure auf der glatten Oberfläche der Membran nur langsam stattfindet. Daher kommt es häufig zu einer inhomogenen Säuredotierung über den Querschnitt der Membran, was zu einer unbefriedigenden Reproduzierbarkeit führt.
So zeigen die bislang bekannten Polymermembran auf Basis von Polyazolen nach ihrer Dotierung mit Säure noch - für den obigen Einsatzzweck - unzureichende mechanische Eigenschaften. Diese mechanische Instabilität zeigt sich in einem geringen E-Modul, einer geringen Reißfestigkeit und einer niedrigen Bruchzähigkeit.

Aufgrund der für PEM-Brennstoffzellen angestrebten Anwendungen, insbesondere im Automobil- und Stationärbereich, ist eine hohe Reproduzierbarkeit der einzusetzenden Membranen jedoch gewünscht und die bisher bekannten Verfahren noch zu verbessern.

Das Dokument WO-A-0204083 offenbart oberflächenmodifizierte Polymermembranen, auf Basis anderer Polymere als Polyazole und deren Verwendung n.A. in der Ultrafiltration.

Aufgabe der vorliegenden Erfindung ist es daher eine Polymermembran auf Basis von Polyazolen bereitzustellen, die einerseits eine homogene Säuredotierung über den gesamten Querschnitt der Membran gewährleistet und gleichzeitig in einem technisch durchführbaren Verfahren erhalten werden kann.

Überraschender Weise wurde nun gefunden, daß eine asymmetrische Polymerfolie auf Basis von Polyazolen, die sowohl eine glatte als auch eine rauhe Seite besitzt, eine wesentlich schnellere und homogenere Säureaufnahme bei der Dotierung erlaubt und somit wirtschaftlich, d.h. in kürzerer Zeit, und mit hoher Reproduzierbarkeit herstellbar ist. Femer besitzen die mit dem erfindungsgemäßen Verfahren hergestellten dotierten Polymermembranen gute mechanische Eigenschaften und eine ausgezeichnete Protonenleitfähigkeit.

Gegenstand der vorliegenden Erfindung ist eine asymmetrische Polymerfolie auf Basis von Polyazolen, die eine glatte und eine rauhe Seite aufweist, wobei die Rauhigkeit der glatten Seite < 2 µm, insbesondere < 1 µm, ist und die Rauhigkeit der rauhen Seite zwischen 3 bis 10 µm, vorzugsweise 4 bis 8,5 µm, insbesondere 4 bis 7 µm, beträgt.

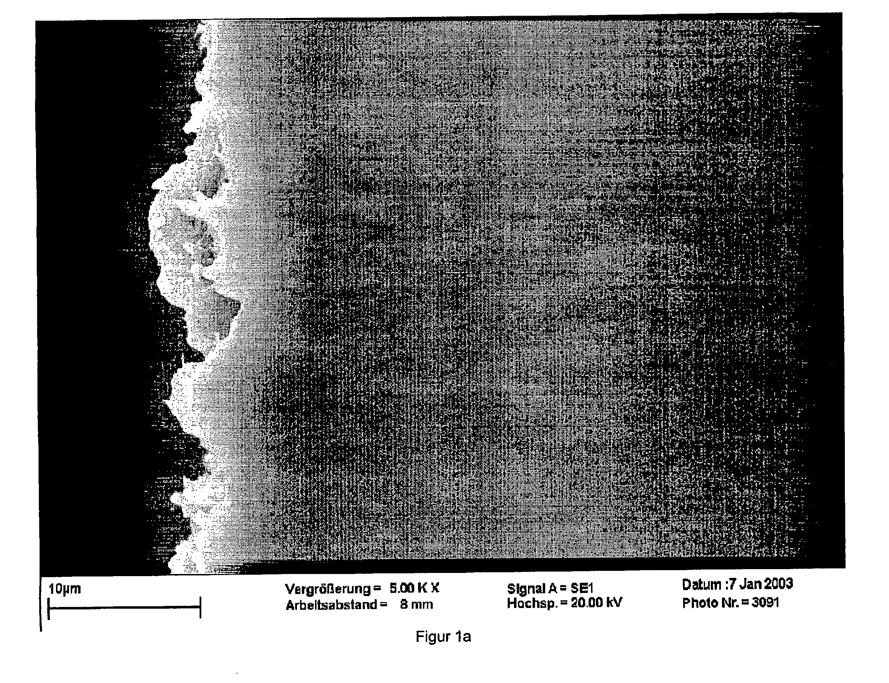

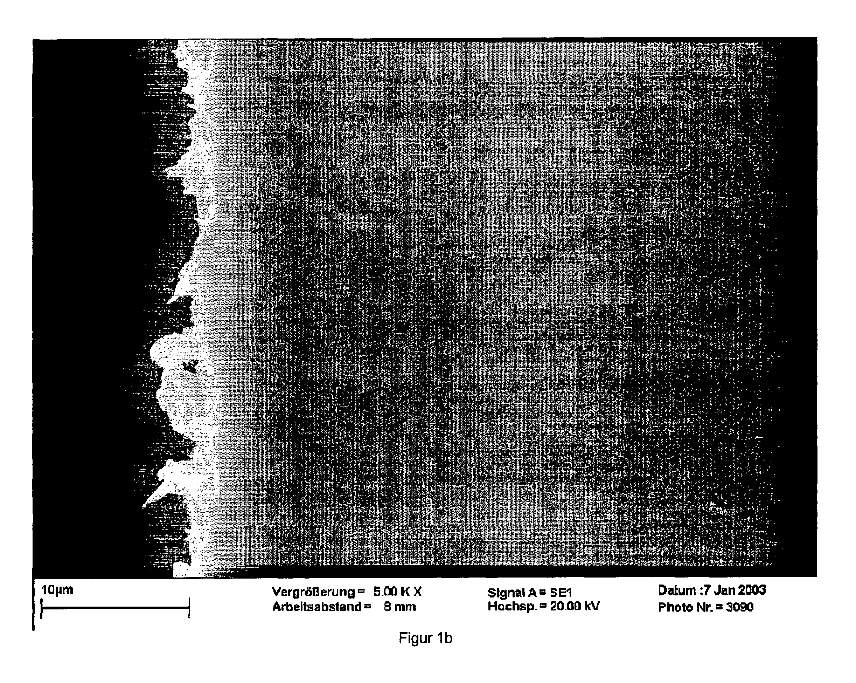

Die Rauhigkeit der erfindungsgemäßen Polymerfolie wird mittels Rasterelektronenmikroskopischen (REM) Aufnahmen bestimmt. Als Rauhigkeit wird die Tiefe der Krater (Schichtdicke) bezeichnet. Wie aus Figur 1 ersichtlich, hat die erfindungsgemäße Polymerfolie deutlich unterschiedliche Oberflächen. Während die glatte Seite eine überwiegend ebenmäßige Struktur mit lediglich kleinere

Unebenheiten in einer Tiefe von < 2 µm, insbesondere < 1 µm erkennen lässt, zeigt die rauhe Seite der Folie eine Schichtdicke (Tiefe) im Bereich von 3 bis 10 µm, vorzugsweise 4 bis 8,5 µm, insbesondere 4 bis 7 µm.

Als Polyazole im Sinne der vorliegenden Erfindung werden Polymere enthaltend wiederkehrende Azoleinheiten der allgemeinen Formel (I) und/oder (II) und/oder (III) und/oder (IV) und/oder (V) und/oder (VI) und/oder (VII) und/oder (VIII) und/oder (IX) und/oder (X) und/oder (XI) und/oder (XII) und/oder (XIII) und/oder (XIV) und/oder (XV) und/oder (XVI) und/oder (XVI) und/oder (XVII) und/oder (XVIII) und/oder (XIX) und/oder (XX) und/oder (XXI) und/oder (XXII) 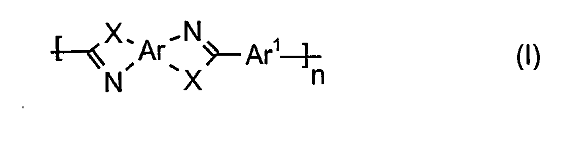 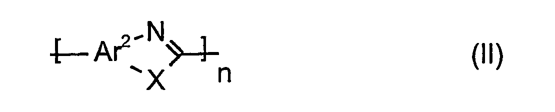 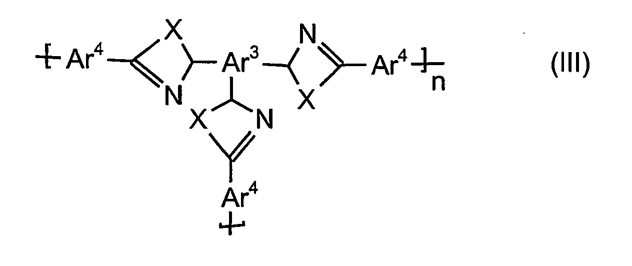 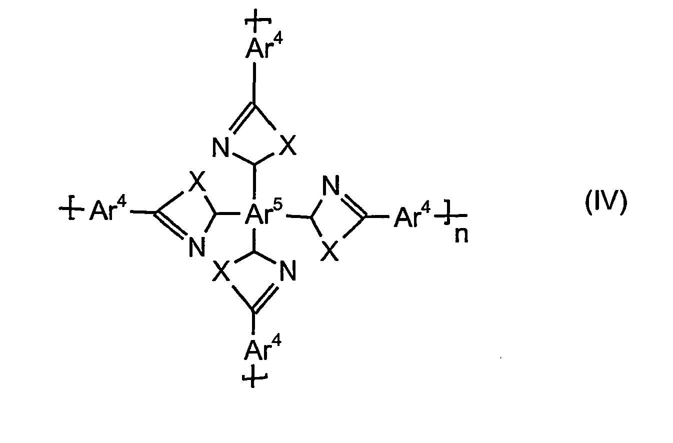 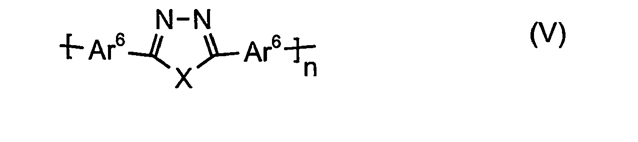 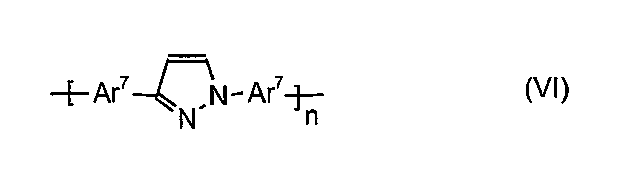 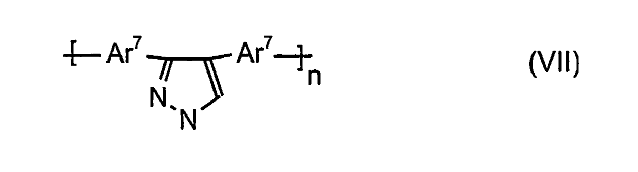 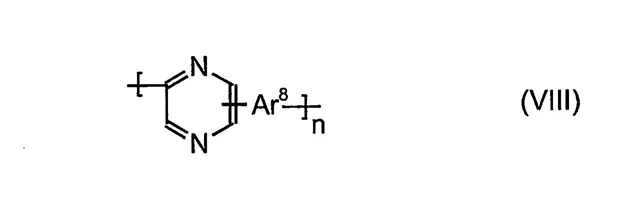 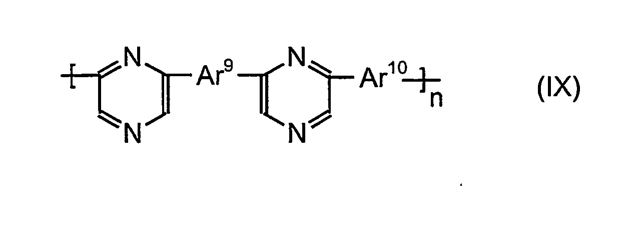 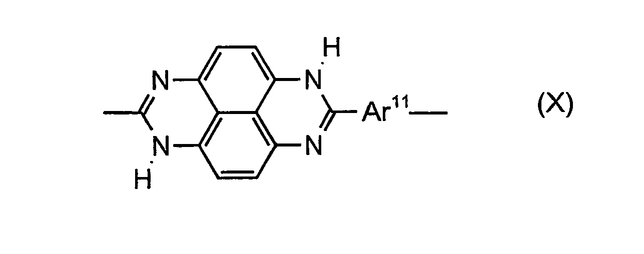 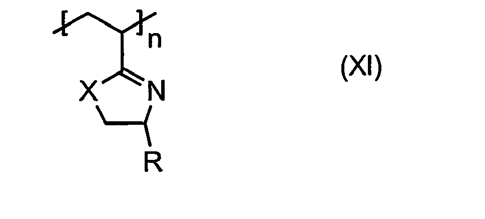 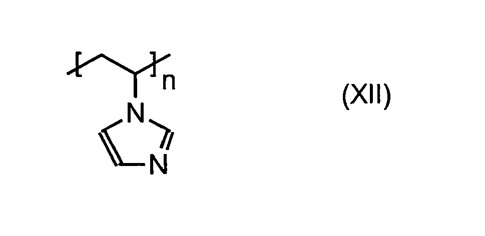 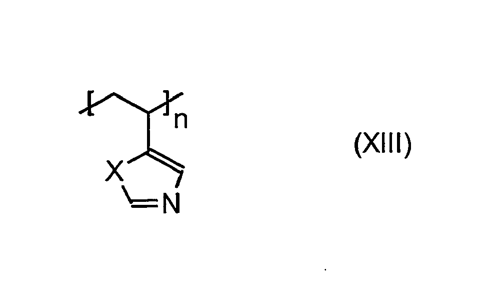 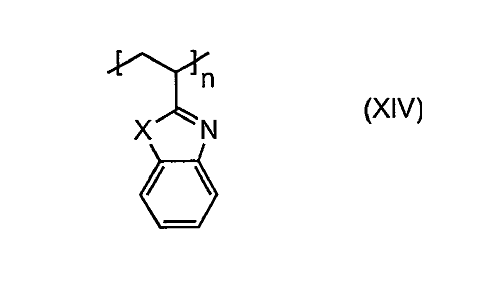 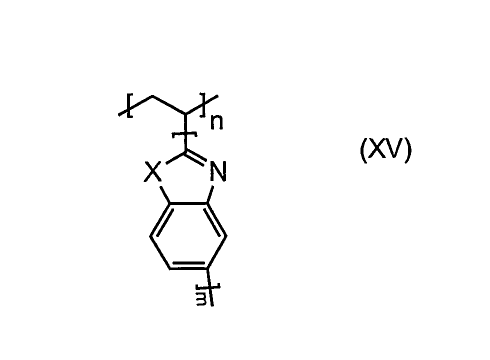 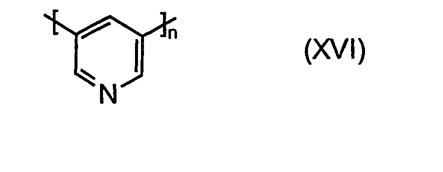 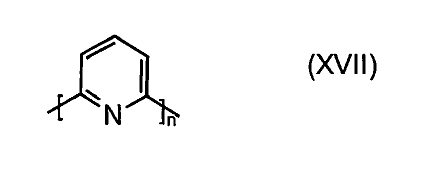 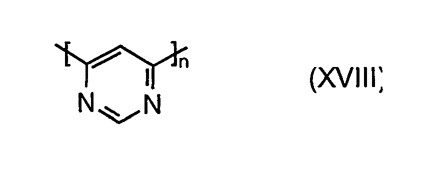 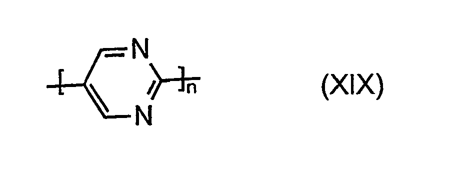 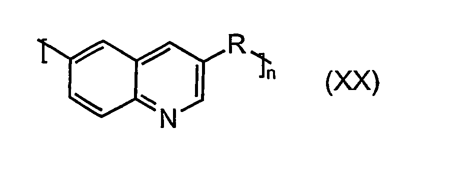 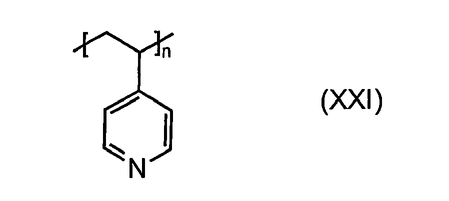 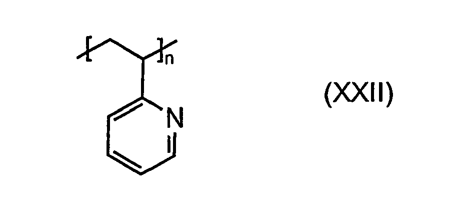 worin
- Ar: gleich oder verschieden sind und für eine vierbindige aromatische oder heteroaromatische Gruppe, die ein- oder mehrkernig sein kann,
- Ar¹: gleich oder verschieden sind und für eine zweibindige aromatische oder heteroaromatische Gruppe, die ein- oder mehrkernig sein kann,
- Ar²: gleich oder verschieden sind und für eine zwei oder dreibindige aromatische oder heteroaromatische Gruppe, die ein- oder mehrkernig sein kann,
- Ar³: gleich oder verschieden sind und für eine dreibindige aromatische oder heteroaromatische Gruppe, die ein- oder mehrkernig sein kann,
- Ar⁴: gleich oder verschieden sind und für eine dreibindige aromatische oder heteroaromatische Gruppe, die ein- oder mehrkernig sein kann,
- Ar⁵: gleich oder verschieden sind und für eine vierbindige aromatische oder heteroaromatische Gruppe, die ein- oder mehrkernig sein kann,
- Ar⁶: gleich oder verschieden sind und für eine zweibindige aromatische oder heteroaromatische Gruppe, die ein- oder mehrkernig sein kann,
- Ar⁷: gleich oder verschieden sind und für eine zweibindige aromatische oder heteroaromatische Gruppe, die ein- oder mehrkernig sein kann,
- Ar⁸: gleich oder verschieden sind und für eine dreibindige aromatische oder heteroaromatische Gruppe, die ein- oder mehrkernig sein kann,
- Ar⁹: gleich oder verschieden sind und für eine zwei- oder drei- oder vierbindige aromatische oder heteroaromatische Gruppe, die ein- oder mehrkernig sein kann,
- Ar¹⁰: gleich oder verschieden sind und für eine zwei- oder dreibindige aromatische oder heteroaromatische Gruppe, die ein- oder mehrkernig sein kann,
- Ar¹¹: gleich oder verschieden sind und für eine zweibindige aromatische oder heteroaromatische Gruppe, die ein- oder mehrkernig sein kann,
- X: gleich oder verschieden ist und für Sauerstoff, Schwefel oder eine Aminogruppe, die ein Wasserstoffatom, eine 1- 20 Kohlenstoffatome aufweisende Gruppe, vorzugsweise eine verzweigte oder nicht verzweigte Alkyl- oder Alkoxygruppe, oder eine Arylgruppe als weiteren Rest trägt
- R: gleich oder verschieden für Wasserstoff, eine Alkylgruppe und eine aromatische Gruppe steht, wobei der Rest R in Formel (XX) ungleich Wasserstoff ist, und
- n, m: eine ganze Zahl größer gleich 10, bevorzugt größer gleich 100 ist, verstanden

Bevorzugte aromatische oder heteroaromatische Gruppen leiten sich von Benzol, Naphthalin, Biphenyl, Diphenylether, Diphenylmethan, Diphenyldimethylmethan, Bisphenon, Diphenylsulfon, Chinolin, Pyridin, Bipyridin, Pyridazin, Pyrimidin, Pyrazin, Triazin, Tetrazin, Pyrol, Pyrazol, Anthracen, Benzopyrrol, Benzotriazol, Benzooxathiadiazol, Benzooxadiazol, Benzopyridin, Benzopyrazin, Benzopyrazidin, Benzopyrimidin, Benzopyrazin, Benzotriazin, Indolizin, Chinolizin, Pyridopyridin, Imidazopyrimidin, Pyrazinopyrimidin, Carbazol, Aciridin, Phenazin, Benzochinolin, Phenoxazin, Phenothiazin, Acridizin, Benzopteridin, Phenanthrolin und Phenanthren, die gegebenenfalls auch substituiert sein können, ab.

Dabei ist das Substitionsmuster von Ar¹, Ar⁴, Ar⁶, Ar⁷, Ar⁸, Ar⁹, Ar¹⁰, Ar¹¹ beliebig, im Falle vom Phenylen beispielsweise kann Ar¹, Ar⁴, Ar⁶, Ar⁷, Ar⁸, Ar⁹, Ar¹⁰, Ar¹¹ ortho-, meta- und para-Phenylen sein. Besonders bevorzugte Gruppen leiten sich von Benzol und Biphenylen, die gegebenenfalls auch substituiert sein können, ab.

Bevorzugte Alkylgruppen sind kurzkettige Alkylgruppen mit 1 bis 4 Kohlenstoffatomen, wie z. B. Methyl-, Ethyl-, n- oder i-Propyl- und t-Butyl-Gruppen.

Bevorzugte aromatische Gruppen sind Phenyl- oder Naphthyl-Gruppen. Die Alkylgruppen und die aromatischen Gruppen können substituiert sein.

Bevorzugte Substituenten sind Halogenatome wie z. B. Fluor, Aminogruppen, Hydroxygruppen oder kurzkettige Alkylgruppen wie z. B. Methyl- oder Ethylgruppen.

Bevorzugt sind Polyazole mit wiederkehrenden Einheiten der Formel (I) bei denen die Reste X innerhalb einer wiederkehrenden Einheit gleich sind.

Die Polyazole können grundsätzlich auch unterschiedliche wiederkehrende Einheiten aufweisen, die sich beispielsweise in ihrem Rest X unterscheiden. Vorzugsweise jedoch weist es nur gleiche Reste X in einer wiederkehrenden Einheit auf.

Weitere bevorzugte Polyazol-Polymere sind Polyimidazole, Polybenzthiazole, Polybenzoxazole, Polyoxadiazole, Polyquinoxalines, Polythiadiazole Poly(pyridine), Poly(pyrimidine), und Poly(tetrazapyrene).

In einer weiteren Ausführungsform der vorliegenden Erfindung ist das Polymer enthaltend wiederkehrende Azoleinheiten ein Copolymer oder ein Blend, das mindestens zwei Einheiten der Formel (I) bis (XXII) enthält, die sich voneinander unterscheiden. Die Polymere können als Blockcopolymere (Diblock, Triblock), statistische Copolymere, periodische Copolymere und/oder alternierende Polymere vorliegen.

In einer besonders bevorzugten Ausführungsform der vorliegenden Erfindung ist das Polymer enthaltend wiederkehrende Azoleinheiten ein Polyazol, das nur Einheiten der Formel (I) und/oder (II) enthält.

Die Anzahl der wiederkehrende Azoleinheiten im Polymer ist vorzugsweise eine ganze Zahl größer gleich 10. Besonders bevorzugte Polymere enthalten mindestens 100 wiederkehrende Azoleinheiten.

Im Rahmen der vorliegenden Erfindung sind Polymere enthaltend wiederkehrenden Benzimidazoleinheiten bevorzugt. Einige Beispiele der äußerst zweckmäßigen Polymere enthaltend wiederkehrende Benzimidazoleinheiten werden durch die nachfolgende Formeln wiedergegeben: 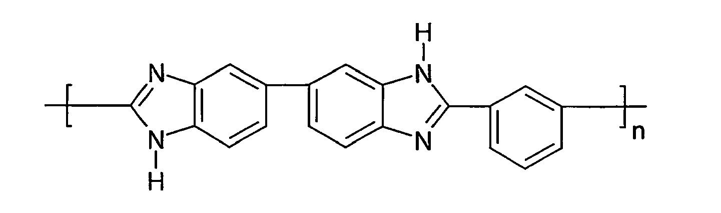 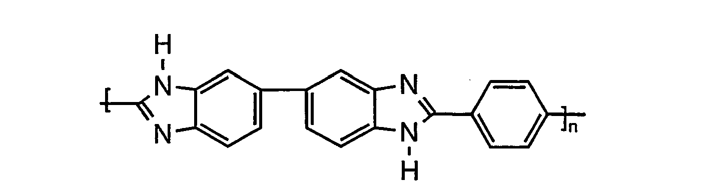 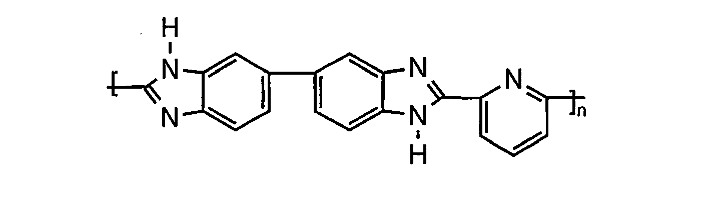 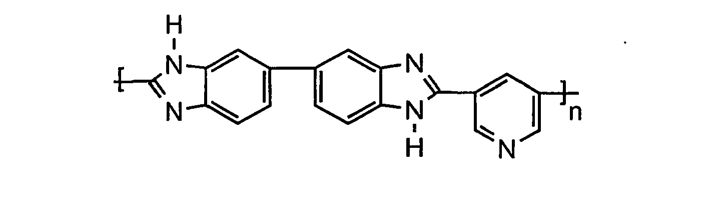 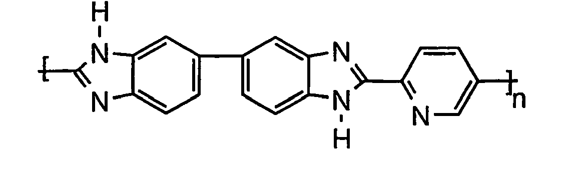 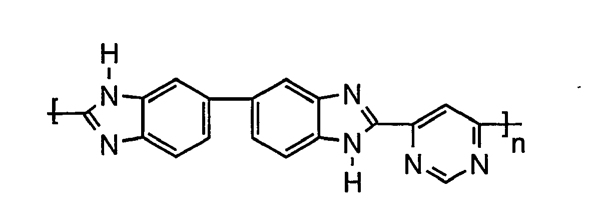 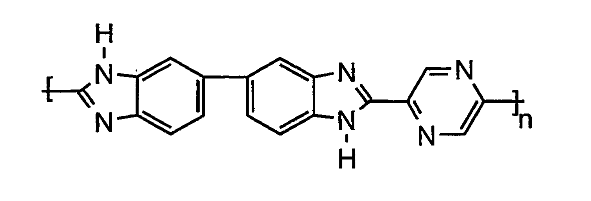 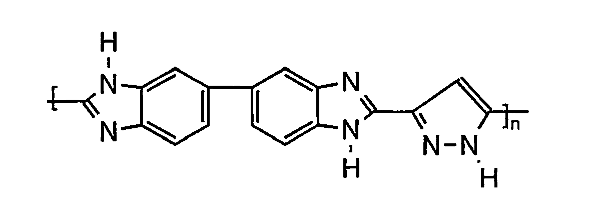 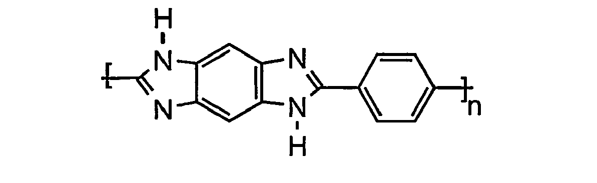 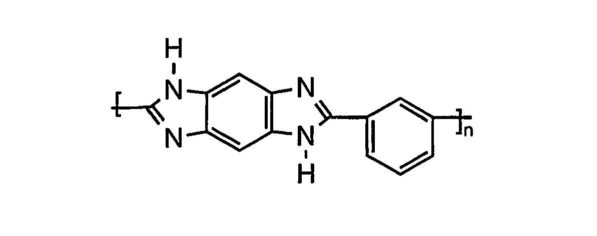 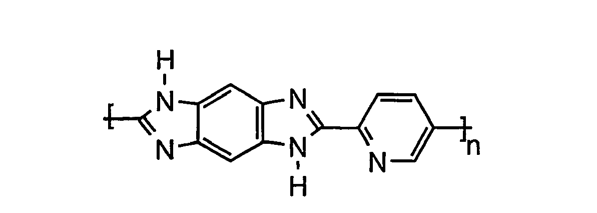 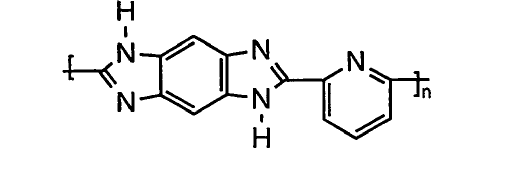 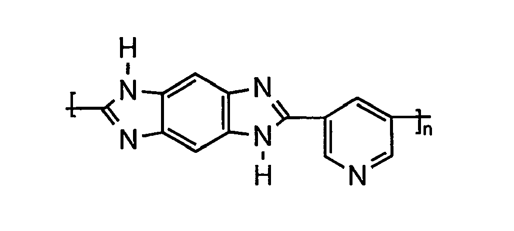 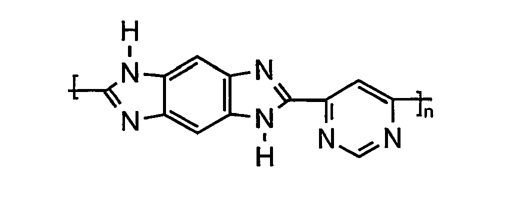 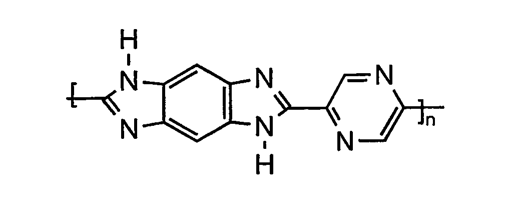 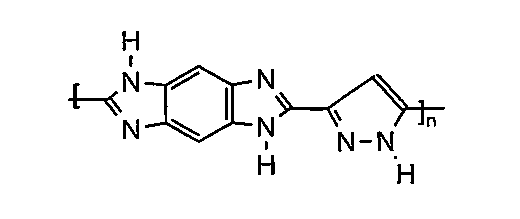 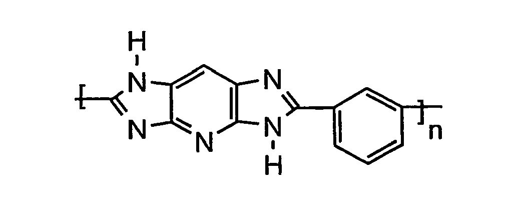 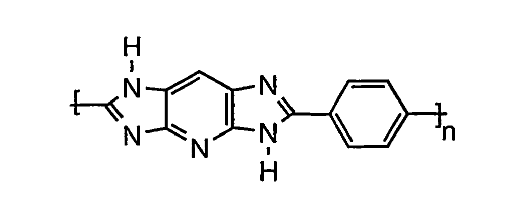 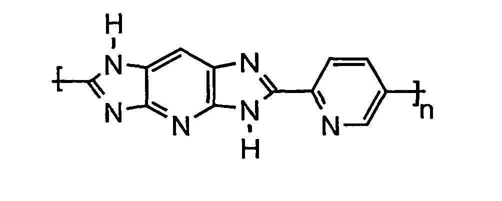 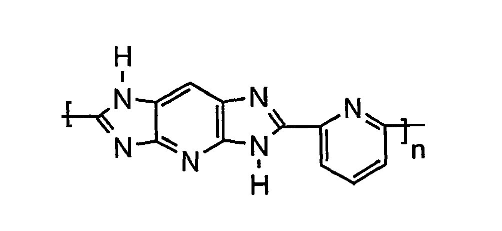 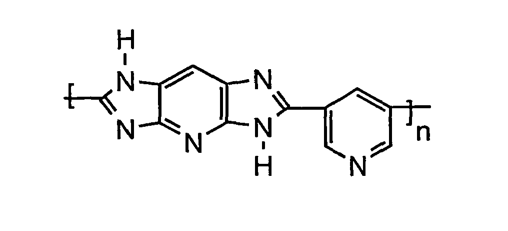 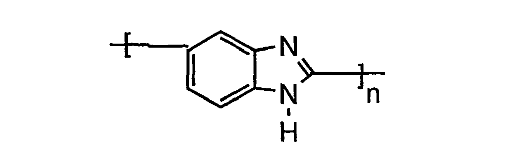 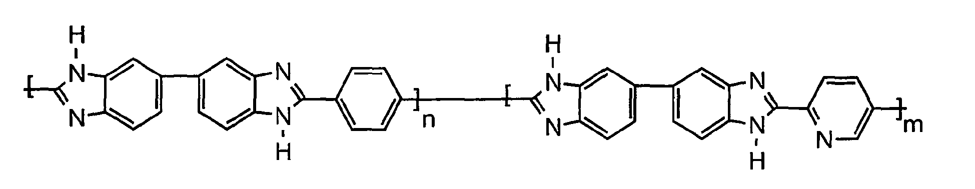 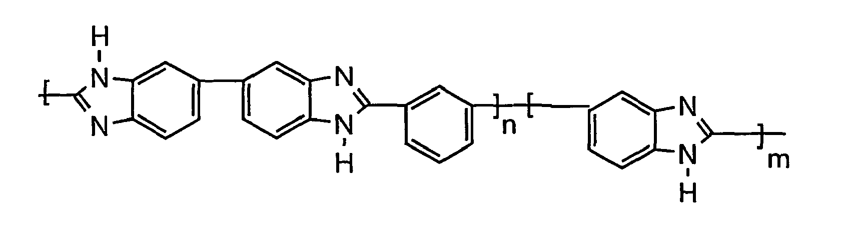 wobei n und m eine ganze Zahl größer gleich 10, vorzugsweise größer gleich 100 ist.

Die eingesetzten Polyazole, insbesondere jedoch die Polybenzimidazole, weisen ein hohes Molekulargewicht aus. Dieses beträgt, gemessen als Intrinsische Viskosität, beträgt diese mindestens 0,8 dl/g, vorzugweise mindestens 1,1 dl/g.

Die Herstellung der erfindungsgemäßen Polymerfolie erfolgt durch die Schritte
A) Aufbringen einer Lösung und/oder Suspension enthaltend Polyazol-Polymer in einem Lösungsmittel auf einen Träger, dessen Oberfläche in einer solchen Weise aufgerauht ist, das die erwünschte Rauhigkeit erhalten wird, unter Ausbildung einer flächigen Schicht,
B) Trocknung der gemäß Schritt A) gebildeten Schicht und
C) Ablösen der getrockneten Polymerfolie vom Träger.

Herstellung von Polymer-Lösungen auf Basis von Polyazolen ist im Stand der Technik eingehend beschrieben. So beschreibt EP-A-0816415 ein Verfahren zum Lösen von Polymeren auf Basis von Polyazolen unter Verwendung von N,N-Dimethylacetamid als polares, aprotisches Lösungsmittel bei Temperaturen oberhalb 260°C. Ein wesentlich schonenderes Verfahren zur Herstellung von Lösungen auf Basis von Polyazolen ist in der deutschen Patentanmeldung 10052237.8 offenbart.

Die Schichtbildung erfolgt mittels an sich bekannter Maßnahmen (Gießen, Sprühen, Rakeln) die aus dem Stand der Technik zur Polymerfilm-Herstellung bekannt sind. Die so erzeugte Schicht hat eine Dicke zwischen 15 und 4000 µm, vorzugsweise zwischen 20 und 3500 µm, insbesondere zwischen 30 und 2000 µm.

Als Träger sind alle unter den Bedingungen als inert zu bezeichnenden Träger geeignet, üblicherweise werden Metallbänder verwendet, es können jedoch auch alle anderen Materialien verwendet werden, die unter den Bedingungen inert sind und die erforderliche Rauheit erlauben. Die Verwendung von Metallbändern erlaubt ferner die Möglichkeit diese mit Legierungen oberflächlich zu beschichten.

Um eine aufgerauhte Oberfläche zu erhalten, auf welche die Polymerlösung erfindungsgemäß aufgebracht werden kann, hat es sich als sinnvoll erwiesen die Oberfläche der Bänder aufzurauen. Möglichkeiten zur Aufrauung sind z.B. die Oberfläche des Metallbandes sandzustrahlen oder anzuschleifen. Derartige Methoden sind dem Fachmann bekannt.

Die auf dem Träger befindliche Schicht wird in Schritt C) anschliessend getrocknet bis die so erzeugte Folie selbsttragend ist. Die dem Träger abgewandte Seite der Folie ist, wie bei den bekannten Verfahren auch glatt und ebenmäßig, während die auf dem Träger befindliche Seite in Analogie zur Oberflächenstruktur des Trägers eine aufgerauhte Oberfläche besitzt.

Die Rasterelektronenmikroskopischen (REM) Aufnahmen zeigen sehr deutlich den Unterschied der Struktur der aufgerauhten und der glatten Seite der Folie.
Die Trocknung der Folie in Schritt C) erfolgt bei Temperaturen zwischen Raumtemperatur und 300°C. Die Trocknung erfolgt unter Normaldruck oder reduziertem Druck. Die Trocknungsdauer ist von der Dicke der so gebildeten Folie abhängig und beträgt zwischen 10 Sekunden und 24 Stunden. Die gemäß Schritt C) getrocknete Folie ist anschließend selbsttragend und kann weiterverarbeitet werden. Die Trocknung erfolgt mittels in der Folienindustrie üblichen Trocknungsverfahren.

Mit Hilfe der in Schritt C) durchgeführten Trocknung wird sofern ein polar, aprotisches organisches Lösungsmittel verwendet wurde, dieses weitestgehend entfernt. Üblicherweise beträgt der Restgehalt an polarem, aprotischen organischen Lösungsmittel nach der Trocknung zwischen 10 - 23 Gew.-%.

Bedingt durch die Trocknung verringert sich die Dicke der Polymerfolie. Diese beträgt nach Trocknung zwischen 10 und 3500 µm, vorzugsweise zwischen 15 und 3000 µm, insbesondere zwischen 25 und 1800 µm.

Eine weitere Absenkung des Rest-Lösemittelgehalten auf unter 2 Gew.-% läßt sich durch eine Erhöhung der Trocknungstemperatur und Trocknungsdauer erzielen, wobei jedoch die nachfolgende Dotierung der Folie, beispielsweise mit Phosphorsäure, deutlich erschwert wird.

Zur Verbesserung der Leistungscharakteristik für Anwendungen als Polymerelektrolytmembran kann die erfindungsgemäße Polymerfolie ein einer nachgeschaltenen Prozedur von Restlösemitteln befreit werden. Das entsprechende Verfahren ist in WO 02/071518 beschrieben.

Die gemäß Schritt C) gebildete asymmetrische Polymerfolie auf Basis von Polyazolen kann anschließend noch weiter behandelt werden. Hierunter wird insbesondere die Vernetzung der Oberfläche verstanden. Diese kann durch Einwirken von Hitze in Gegenwart von Luftsauerstoff an der Oberfläche erfolgen. Diese Härtung der Folienoberfläche verbessert die Eigenschaften der Folie zusätzlich.

Des weiteren kann die Vernetzung auch durch Einwirken von IR bzw. NIR (IR = InfraRot, d. h. Licht mit einer Wellenlänge von mehr als 700 nm; NIR = Nahes IR, d. h. Licht mit einer Wellenlänge im Bereich von ca. 700 bis 2000 nm bzw. einer Energie im Bereich von ca. 0.6 bis 1.75 eV) erfolgen. Eine weitere Methode ist die Bestrahlung mit β-Strahlen. Die Strahlungsdosis beträgt hierbei zwischen 5 und 200 kGy.

Zur Dotierung wird die gemäß Schritt C) erhaltenen Folie mit einem Dotierungsmittel benetzt oder in diesem eingelegt. Als Dotierungsmittel für die erfindungsgemäßen Polymermembranen werden Säuren vorzugsweise alle bekannten Lewis- und Brønsted-Säuren, insbesondere anorganische Lewis- und Brønsted-Säuren eingesetzt.
Neben diesen vorstehend genannten Säure ist auch der Einsatz von Polysäuren möglich, insbesondere Isopolysäuren und Heteropolysäuren sowie von Mischungen verschiedener Säuren. Dabei bezeichnen im Sinne der vorliegenden Erfindung Heteropolysäuren anorganische Polysäuren mit mindestens zwei verschiedenen Zentralatomen, die aus jeweils schwachen, mehrbasischen Sauerstoff-Säuren eines Metalls (vorzugsweise Cr, Mo, V, W) und eines Nichtmetalls (vorzugsweise As, I, P, Se, Si, Te) als partielle gemischte Anhydride entstehen. Zu ihnen gehören unter anderen die 12-Molybdatophosphorsäure und die 12-Wolframatophosphorsäure.

Besonders bevorzugte Dotierungsmittel sind Schwefelsäure und Phosphorsäure. Ein ganz besonders bevorzugtes Dotierungsmittel ist Phosphorsäure (H₃PO₄).

Bei der Dotierung der erfindungsgemäßen Folien hat sich überraschend gezeigt, daß die Säure auf der rauhen Seite der Folie sehr schnell einzieht.
Bringt man z.B. einen Tropfen Phosphorsäure (85%ige Phophorsäure) auf die rauhe Oberfläche der Folie auf, so zeigt sich, daß die Phosphorsäure sehr schnell in die Folie eindringt. Mit zunehmenden Einsinken des Tropfens in die Folie nimmt der Kontaktwinkel stetig ab. Bei den erfindungsgemäßen Folien beobachtet man eine Abnahme des Kontaktwinkels auf Werte von < 10° innerhalb von 1 Minute nach Aufbringen des Tropfens.
Bei Aufbringen eines Phosphorsäuretropfens auf eine glatte Folienoberfläche kommt es dagegen lediglich zu einer Aufspreizung des Tropfens. Der Kontaktwinkel nimmt wesentlich langsamer ab. Nach 10 Minuten liegt der Kontaktwinkel noch bei > 35°, ohne daß der Phosphorsäuretropfen ganz von der Folie aufgenommen wird.

Bei der Dotierung der erfindungsgemäßen asymmetrischen Polymerfolie auf der aufgerauhten Seite kommt es zu einer homogenen Säureaufnahme. Ein weiterer Vorteil liegt in der verbesserten Reproduzierbarkeit der Dotierung der vorliegenden Folien im Vergleich zu herkömmlichen Folien und einer Zeiterspamis des Dotiervorganges, was insbesondere bei der großtechnischen Herstellung der Polymerelektrolytmembranen von Bedeutung ist.

Die erfindungsgemäßen asymmetrischen Polymerfolien werden vorzugsweise dotiert. Im Rahmen der vorliegenden Erfindung bezeichnen dotierte Polymermembranen solche Polymermembranen, die aufgrund der Gegenwart von Dotierungsmitteln eine erhöhte Protonenleitfähigkeit im Vergleich mit den nicht dotierten Polymermembranen zeigen.

Verfahren zur Herstellung von dotierten Polymermembran sind bekannt. In einer bevorzugten Ausführungsform der vorliegenden Erfindung werden sie erhalten, indem man eine Folie des betreffenden Polymeren über eine geeignete Zeit, vorzugsweise 1 Minute - 96 Stunden, besonders bevorzugt 10 Minuten - 50 Stunden, bei Temperaturen zwischen Raumtemperatur und 100°C und gegebenenfalls erhöhtem Druck mit konzentrierter Säure, vorzugsweise mit hochkonzentrierter Phosphorsäure, wie vorstenend beschrieben benetzt. Der Dotiervorgang kann bei den erfindungsgemäßen Membranen bis auf 1/5 der ursprünglichen Zeit verkürzt werden, da die Säureaufnahme auf der aufgerauhten Membranseite erheblich schneller geschieht.

Über den Dotierungsgrad kann die Leitfähigkeit der erfindungsgemäßen Polymermembran beeinflußt werden. Dabei nimmt die Leitfähigkeit mit steigender Konzentration an Dotierungsmittel solange zu, bis ein maximaler Wert erreicht ist. Erfindungsgemäß wird der Dotierungsgrad angegeben als Mol Säure pro Mol Wiederholungseinheit des Polymers. Im Rahmen der vorliegenden Erfindung ist ein Dotierungsgrad zwischen 3 und 15, insbesondere zwischen 6 und 12, bevorzugt.

Zur weiteren Verbesserung der anwendungstechnischen Eigenschaften können der Membran bzw. der Folie zusätzlich noch Füllstoffe, insbesondere protonenleitende Füllstoffe, sowie zusätzliche Säuren zugesetzt werden. Die Zugabe erfolgt überlicherweise bei Schritt A).

Nicht limitierende Beispiele für Protonenleitende Füllstoffe sind
- Sulfate wie:: C_{S}HSO₄, Fe(SO₄)₂, (NH₄)₃H(SO₄)₂, LiHSO₄, NaHSO₄, KHSO₄, RbSO₄, LiN₂H₅SO₄, NH₄HSO₄,
- Phosphate wie: Zr₃(PO₄)₄, Zr(HPO₄)₂, HZr₂(PO₄)₃, UO₂PO₄.3H₂O, H₈UO₂PO₄, Ce(HPO₄)₂, Ti(HPO₄)₂, KH₂PO₄, NaH₂PO₄, LiH₂PO₄, NH₄H₂PO₄, CsH₂PO₄, CaHPO₄, MgHPO₄, HSbP₂O₈, HSb₃P₂O₁₄, H₅Sb₅P₂O₂₀,
- Polysäure wie: H₃PW₁₂O₄₀.nH₂O (n=21-29), H₃SiW₁₂O₄₀.nH₂O (n=21-29), HₓWO₃, HSbWO₆, H₃PMo₁₂O₄₀, H₂Sb₄O₁₁, HTaWO₆, HNbO₃, HTiNbO₅, HTiTaO₅, HSbTeO₆, H₅Ti₄O₉, HSbO₃, H₂MoO₄
- Selenite und Arsenide wie: (NH₄)₃H(SeO₄)₂, UO₂AsO₄, (NH₄)₃H(SeO₄)₂, KH₂AsO₄, Cs₃H(SeO₄)₂, Rb₃H(SeO₄)₂,
- Oxide wie: Al₂O₃, Sb₂O₅, ThO₂, SnO₂, ZrO₂, MoO₃
- Silikate wie: Zeolithe, Zeolithe(NH₄+), Schichtsilikate, Gerüstsilikate, H-Natrolite, H-Mordenite, NH₄-Analcine, NH₄-Sodalite, NH₄-Gallate, H- Montmorillonite
- Säuren wie: HClO₄, SbF₅
- Füllstoffe wie: Carbide, insbesondere SiC, Si₃N₄, Fasern, insbesondere Glasfasern, Glaspulvern und/oder Polymerfasern, bevorzugt auf Basis von Polyazolen.

Als weiteres kann diese Membran auch perfluorierte Sulfonsäure Additive (0,1-20 wt%, bevorzugt 0,2-15 wt%, ganz bevorzugt 0,2-10 wt%) enthalten. Diese Additive führen zur Leistungsverbesserung, in der Nähe der Kathode zur Erhöhung der Sauerstofflöslichkeit und Sauerstoffdiffusion und zur Verringerung der Adsorbtion von Phosphorsäure und Phosphat zu Platin. (Electrolyte additives for phosphoric acid fuel cells. Gang, Xiao; Hjuler, H. A.; Olsen, C.; Berg, R. W.; Bjerrum, N. J.. Chem. Dep. A, Tech. Univ. Denmark, Lyngby, Den. J. Electrochem. Soc. (1993), 140(4), 896-902 und Perfluorosulfonimide as an additive in phosphoric acid fuel cell.
Razaq, M.; Razaq, A.; Yeager, E.; DesMarteau, Darryl D.; Singh, S. Case Cent.
Electrochem. Sci., Case West. Reserve Univ., Cleveland, OH, USA. J.
Electrochem. Soc. (1989), 136(2), 385-90.)
Nicht limitierende Beispiele für persulfonierte Additive sind:
Trifluomethansulfonsäure, Kaliumtrifluormethansulfonat,
Natriumtrifluormethansulfonat, Lithiumtrifluormethansulfonat,
Ammoniumtrifluormethansulfonat, Kaliumperfluorohexansulfonat,
Natriumperfluorohexansulfonat, Lithiumperfluorohexansulfonat,
Ammoniumperfluorohexansulfonat, Perfluorohexansulfonsäure,
Kaliumnonafluorbutansulfonat, Natriumnonafluorbutansulfonat,
Lithiumnonafluorbutansulfonat, Ammoniumnonafluorbutansulfonat,
Cäsiumnonafluorbutansulfonat, Triethylammoniumperfluorohexasulfonat,
Perflurosulfoimide und Nafion.

Als weiteres kann die Membran bzw. Folie auch als Additive enthalten, die die im Betrieb bei der Sauerstoffreduktion erzeugten Peroxidradikale abfangen (primäre Anitoxidanzien) oder zerstören (sekundäre Antioxidanzien) und dadurch wie in JP2001118591 A2 beschrieben Lebensdauer und Stabilität der Membran und Membranelektrodeneinheit verbessern. Die Funktionsweise und molekularen Strukturen solcher Additive sind in F. Gugumus in Plastics Additives, Hanser Verlag, 1990; N.S. Allen, M. Edge Fundamentals of Polymer Degradation and Stability, Elsevier, 1992; oder H. Zweifel, Stabilization of Polymeric Materials, Springer, 1998 beschrieben.
Nicht limitierende Beispiele für solche Additive sind:
Bis(trifluormethyl)nitroxid, 2,2-Diphenyl-1-pikrinylhydrazyl, Phenole, Alkylphenole, sterisch gehinderte Alkylphenole wie zum Beispiel Irganox, aromatische Amine, sterisch gehinderte Amine wie zum Beispiel Chimassorb; sterisch gehinderte Hydroxylamine, sterisch gehinderte Alkylamine, sterisch gehinderte Hydroxylamine, sterisch gehinderte Hydroxylaminether, Phosphite wie zum Beispiel Irgafos, Nitrosobenzol, Methyl.2-nitroso-propan, Benzophenon, Benzaldehyd-tert.-butylnitron, Cysteamin, Melanine, Bleioxide, Manganoxide, Nickeloxide, Cobaltoxide.

Zu möglichen Einsatzgebieten der erfindungsgemäßen Polymerfolien gehört unter anderem die Verwendung als Filtermedium, insbesondere in der Gasfiltration und - trennung bzw. Gasaufreinigung, sowie in der Umkehr-Osmose, als Substrat in der Elektronikindustrie, insbesondere für flexible elektrische Schaltungen, gedruckte elektrische Schaltungen, in Transistoren, Kondensatoren und anderen elektronischen Bauteilen, als Batterieseparatoren, als Schutzfolie für elektrische Kabel, als Isolator in elektrischen Bauteilen und Vorrichtungen wie Kondensatoren, als Schutzfolie für Metall- und sonstige Oberflächen.

Zu möglichen Einsatzgebieten der erfindungsgemäßen, dotierten Polymermembranen gehören unter anderem die Verwendung in Brennstoffzellen, bei der Elektrolyse, in Kondensatoren und in Batteriesystemen. Aufgrund ihres Eigenschaftsprofils werden die dotierten Polymermembranen vorzugsweise in Brennstoffzellen verwendet.

Die vorliegende Erfindung betrifft auch eine Membran-Elektroden-Einheit, die mindestens eine erfindungsgemäße asymmetrische dotierte Polymermembran aufweist. Für weitere Informationen über Membran-Elektroden-Einheiten wird auf die Fachliteratur, insbesondere auf die Patente US-A-4,191,618, US-A-4,212,714 und US-A-4,333,805 verwiesen. Die in den vorstehend genannten Literaturstellen [US-A-4,191,618, US-A-4,212,714 und US-A-4,333,805] enthaltene Offenbarung hinsichtlich des Aufbaues und der Herstellung von Membran-Elektroden-Einheiten ist auch Bestandteil der Beschreibung.

Nachfolgend wird die Erfindung durch Beispiele und Vergleichsbeispiel eingehender erläutert, ohne daß die Erfindung auf diese Beispiele beschränkt werden soll.

### Beispiele:

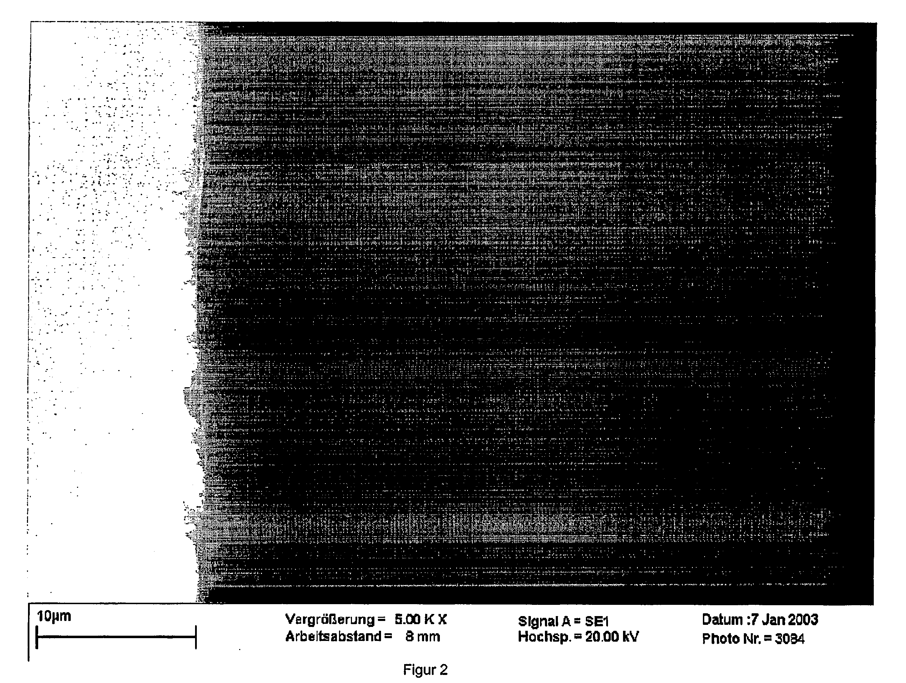

Figuren 1a und 1 b zeigen Rasterelektronenmikroskopische Aufnahmen der aufgerauhten Seite einer erfindungsgemäßen asymmetrischen Polyazolmembran. Wie zu erkennen ist, ist die Membran über eine Schichtdicke (Tiefe) von 4,775 µm (Figur 1 b) bzw. 6,350 µm (Figur 1 a) aufgerauht.
Im Vergleich dazu zeigt das Figur 2 eine Rasterelektronenmikroskopische Aufnahmen der glatten Seite einer Polyazolmembran. Im Vergleich zu Figuren 1a und 1 b ist hier eine überwiegend ebenmäßige Oberfläche erkennbar. Die feinen Unebenheiten lassen sich erst bei einer starken Vergrößerung genauer wahrnehmen und gehen über eine Schichtdicke von 2 µm nicht hinaus.

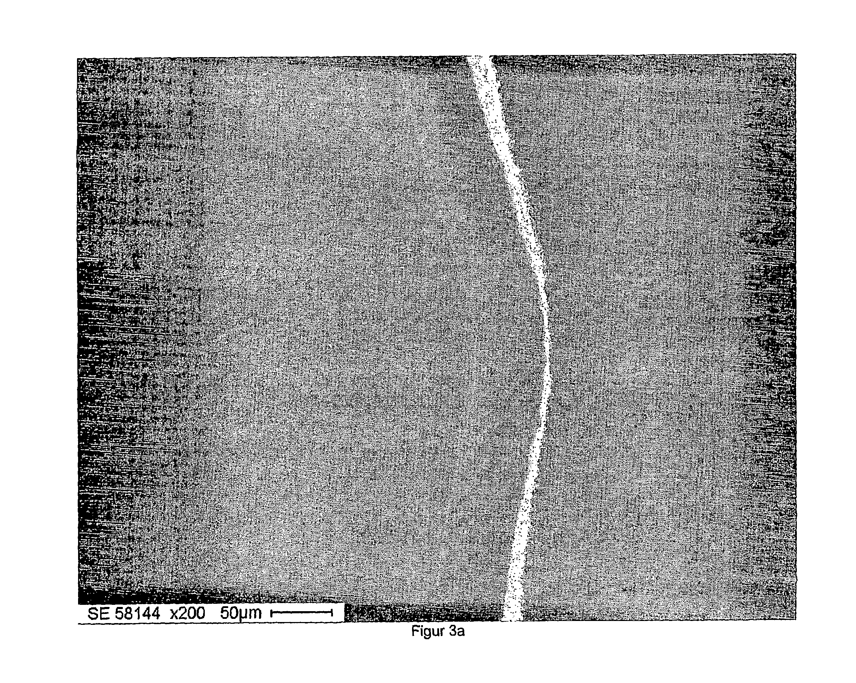

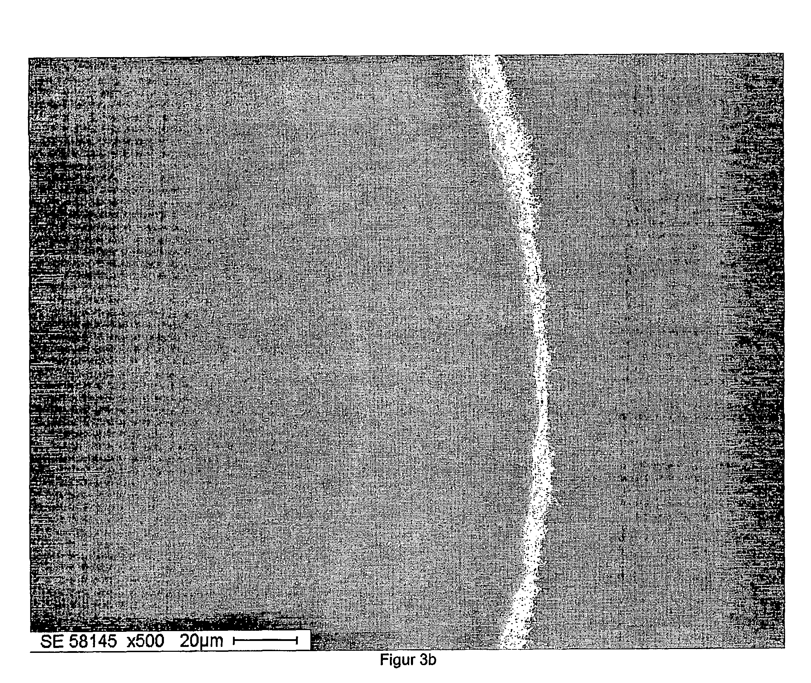

Figuren 3a und 3b zeigen noch einmal die erfindungsgemäße asymmetrische Membran über den gesamten Durchmesser. Auch hier ist wieder der Unterschied zwischen der aufgerauhten und der glatten Membranseite deutlich erkennbar.

### Beispiel 1:

### Messung des Kontaktwinkels

Vergleich der Eindringgeschwindigkeit eines Phophorsäuretropfens auf der glatten und der rauhen Oberfläche einer erfindungsgemäß hergestellten asymmetrischen Polyazolmembran.

Auf den Membranoberfläche wird ein Phosphorsäuretropfen erzeugt und mittels eines Lichtmikroskops der Kontaktwinkel gemessen. Dieser ergibt sich aus der Tropfenkonturenanalyse aus den Mittelwerten der beiden Tangenten an der Grenzfläche Luft/ Film / Phosphorsäure.

Auf eine erfindungsgemäß erhaltene asymmetrische Polyazolmembran wird ein Tropfen 85%ige Phophorsäure auf die aufgerauhte Seite der Folie aufgebracht. Es ist deutlich erkennbar, daß der Säuretropfen schnell in die rauhe Oberfläche einzieht. Der Kontaktwinkel nimmt innerhalb von einer Minute auf einen Wert von < 10° ab.

Der gleiche Versuch wird auf der zwei glatten Seite der Polyazolmembran durchgeführt. Im Unterschied zum vorher durchgeführten Versuch spreizte sich der Tropfen lediglich auf der Membranoberfläche auf. Auch nach 10 Minuten war der Säuretropfen noch nicht nennenswert in die Oberfläche der Membran eingedrungen. Der Kontaktwinkel lag nach 10 Minuten immer noch bei > 35°.

Die Messung des Kontaktwinkels als Funktion der Zeit wurden aus einer Tropfenkonturenanalyse unter Verwendung eines Kontaktwinkelmessgeräts Typ G10/DAS 10 der Firma Krüss bestimmt.

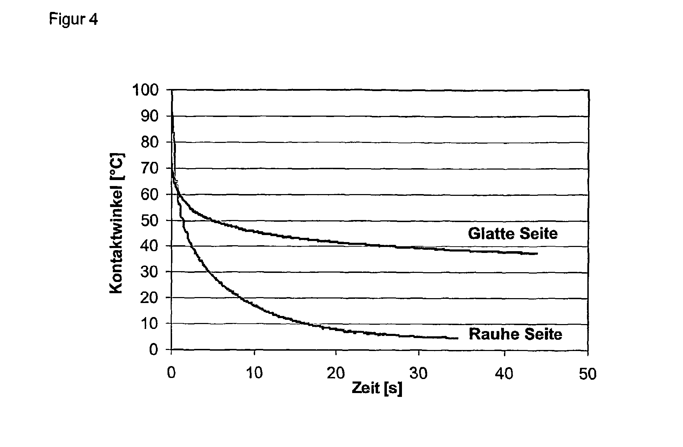

Figur 4 zeigt die Abnahme des Kontaktwinkel als Funktion der Zeit auf der glatten und der rauhen Membranoberfläche. Es ist deutlich zu erkennen, daß nach einiger Zeit ein konstanter Wert erreicht wird und keine weitere nennenswerte Flüssigkeitsaufnahme mehr erfolgt. Die Aufnahme der Säure erfolgte auf der aufgerauhten Seite der Folie nicht nur wesentlich schneller, sondern auch vollständiger.

## Patentansprüche

1. Polymerfolie auf Basis von Polyazolen, die eine glatte und eine rauhe Seite aufweist, wobei die Rauhigkeit der glatten Seite < 2 µm und die Rauhigkeit der rauhen Seite zwischen 3 bis 10 µm beträgt.

2. Polymerfolie gemäß Anspruch 1, **dadurch gekennzeichnet, daß** es sich um ein Polyazol enthaltend wiederkehrende Azoleinheiten der allgemeinen Formel (I) und/oder (II) und/oder (III) und/oder (IV) und/oder (V) und/oder (VI) und/oder (VII) und/oder (VIII) und/oder (IX) und/oder (X) und/oder (XI) und/oder (XII) und/oder (XIII) und/oder (XIV) und/oder (XV) und/oder (XVI) und/oder (XVI) und/oder (XVII) und/oder (XVIII) und/oder (XIX) und/oder (XX) und/oder (XXI) und/oder (XXII) 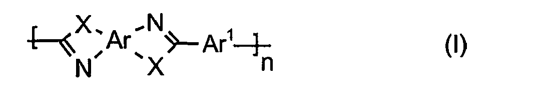 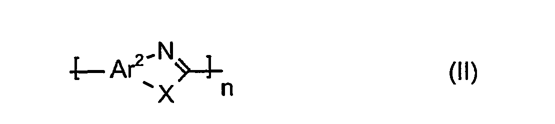 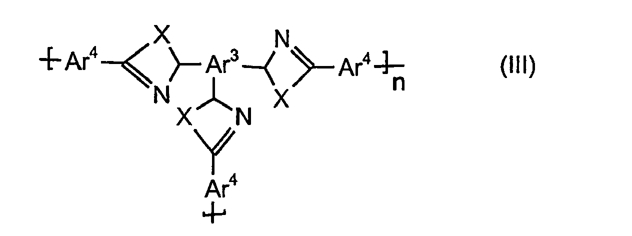 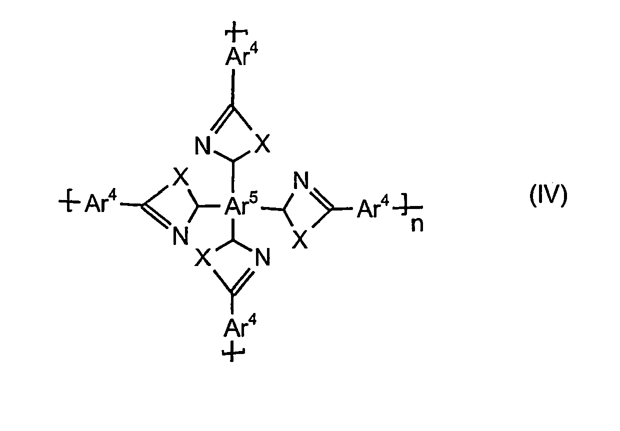 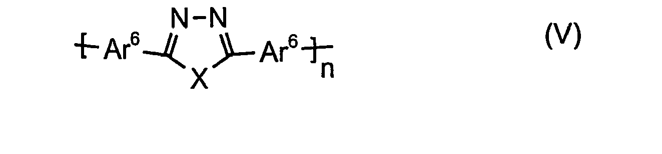 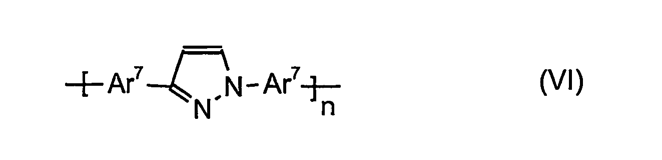 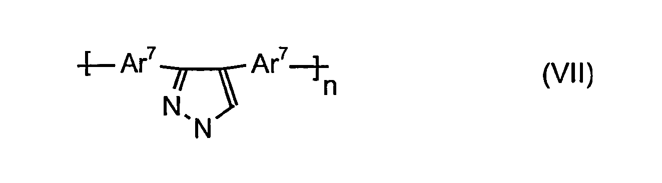 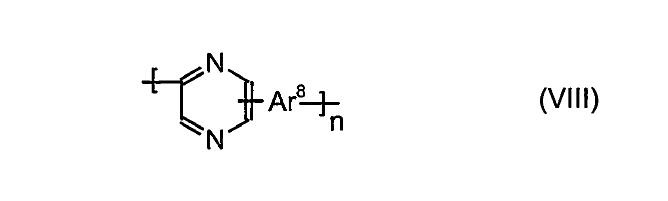 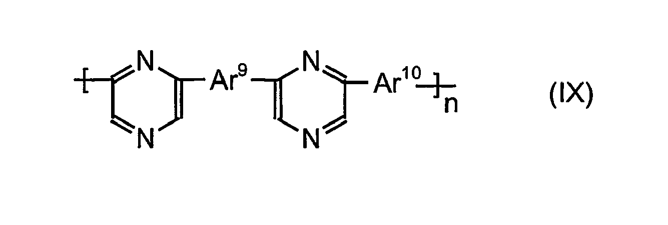 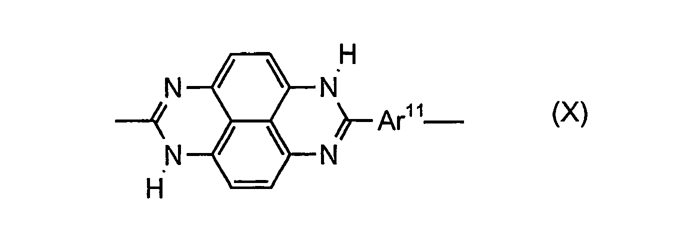 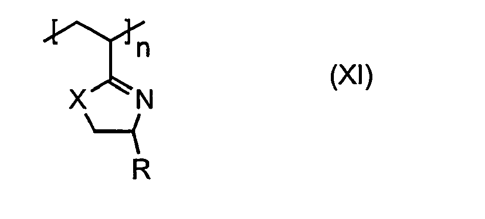 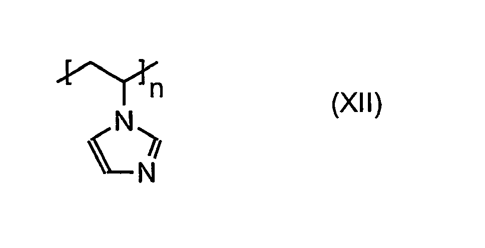 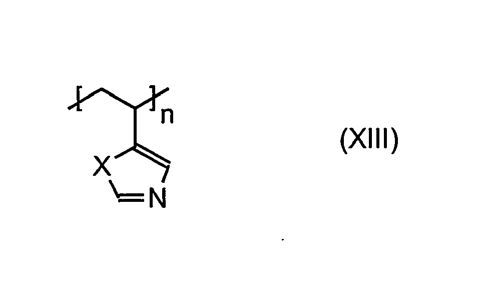 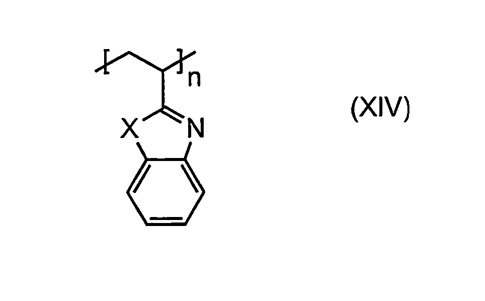 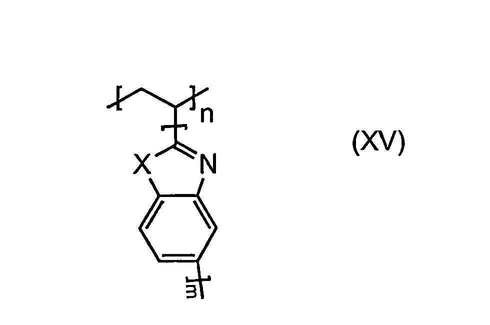 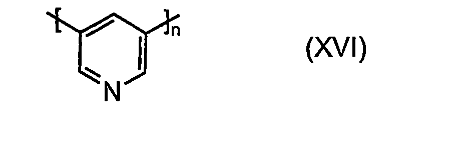 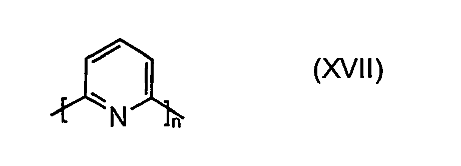 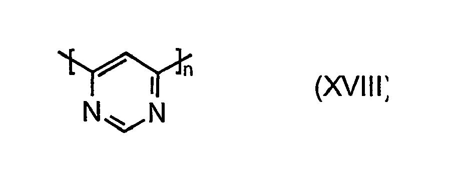 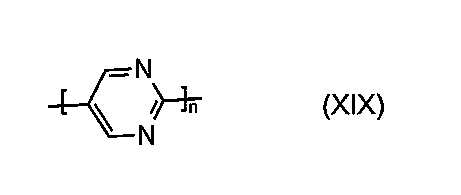 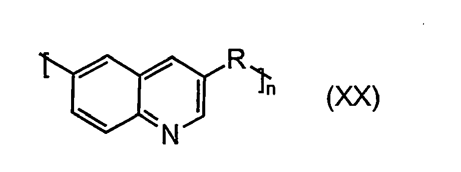 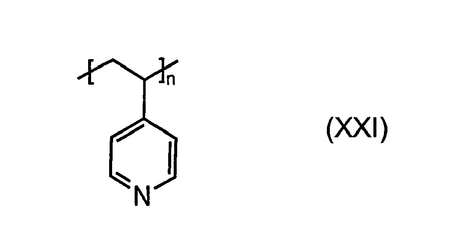 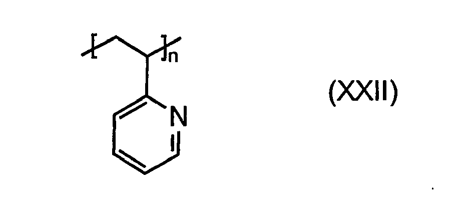 worin
Ar gleich oder verschieden sind und für eine vierbindige aromatische oder heteroaromatische Gruppe, die ein- oder mehrkernig sein kann,
Ar¹ gleich oder verschieden sind und für eine zweibindige aromatische oder heteroaromatische Gruppe, die ein- oder mehrkernig sein kann,
Ar² gleich oder verschieden sind und für eine zwei oder dreibindige aromatische oder heteroaromatische Gruppe, die ein- oder mehrkernig sein kann,
Ar³ gleich oder verschieden sind und für eine dreibindige aromatische oder heteroaromatische Gruppe, die ein- oder mehrkernig sein kann,
Ar⁴ gleich oder verschieden sind und für eine dreibindige aromatische oder heteroaromatische Gruppe, die ein- oder mehrkernig sein kann,
Ar⁵ gleich oder verschieden sind und für eine vierbindige aromatische oder heteroaromatische Gruppe, die ein- oder mehrkernig sein kann,
Ar⁶ gleich oder verschieden sind und für eine zweibindige aromatische oder heteroaromatische Gruppe, die ein- oder mehrkernig sein kann,
Ar⁷ gleich oder verschieden sind und für eine zweibindige aromatische oder heteroaromatische Gruppe, die ein- oder mehrkernig sein kann,
Ar⁸ gleich oder verschieden sind und für eine dreibindige aromatische oder heteroaromatische Gruppe, die ein- oder mehrkernig sein kann,
Ar⁹ gleich oder verschieden sind und für eine zwei- oder drei- oder vierbindige aromatische oder heteroaromatische Gruppe, die ein- oder mehrkernig sein kann,
Ar¹⁰ gleich oder verschieden sind und für eine zwei- oder dreibindige aromatische oder heteroaromatische Gruppe, die ein- oder mehrkernig sein kann,
Ar¹¹ gleich oder verschieden sind und für eine zweibindige aromatische oder heteroaromatische Gruppe, die ein- oder mehrkernig sein kann,
X gleich oder verschieden ist und für Sauerstoff, Schwefel oder eine Aminogruppe, die ein Wasserstoffatom, eine 1- 20 Kohlenstoffatome aufweisende Gruppe, vorzugsweise eine verzweigte oder nicht verzweigte Alkyl- oder Alkoxygruppe, oder eine Arylgruppe als weiteren Rest trägt
R gleich oder verschieden für Wasserstoff, eine Alkylgruppe und eine aromatische Gruppe steht, wobei der Rest R in Formel (XX) ungleich Wasserstoff ist, und
n, m eine ganze Zahl größer gleich 10, bevorzugt größer gleich 100 ist, handelt

3. Polymerfolie gemäß Anspruch 1, **dadurch gekennzeichnet, daß** es sich um ein Polyazol enthaltend wiederkehrende Azoleinheiten der allgemeinen Formel 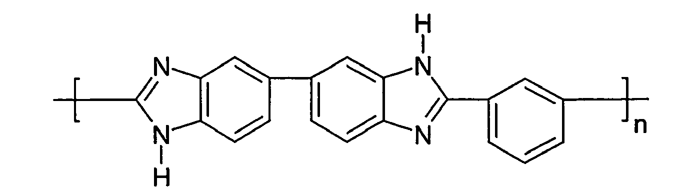 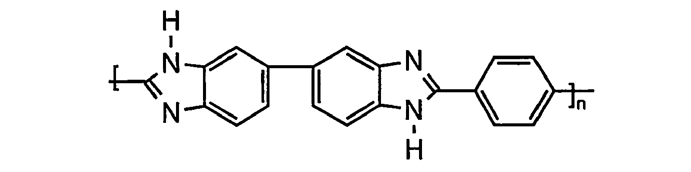 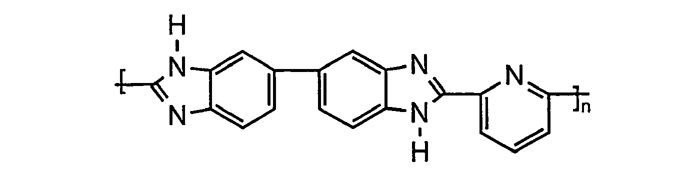 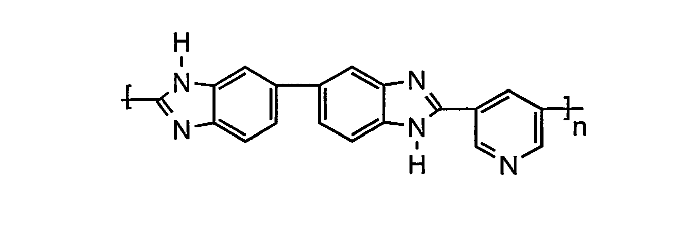 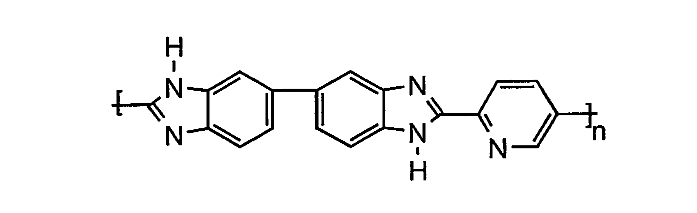 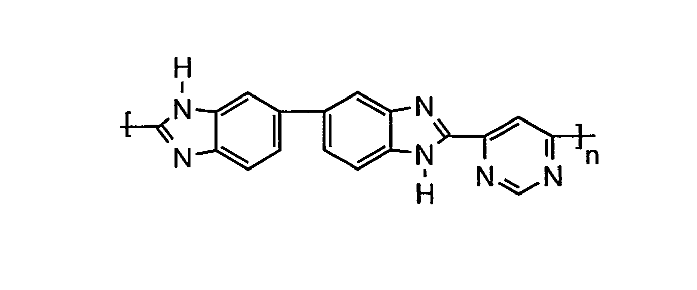 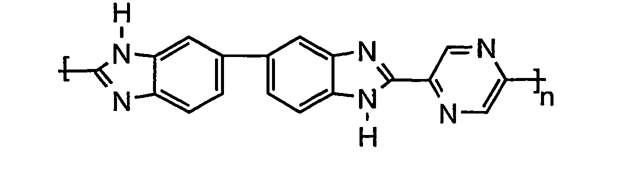 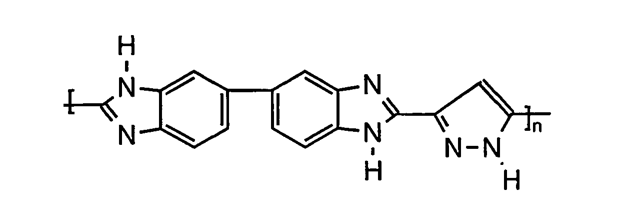 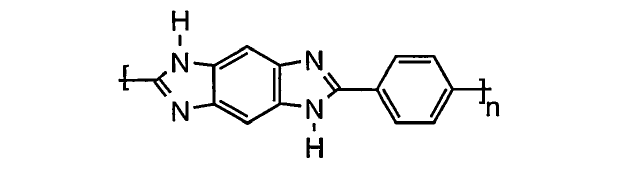 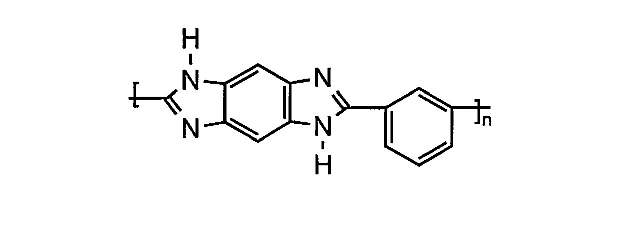 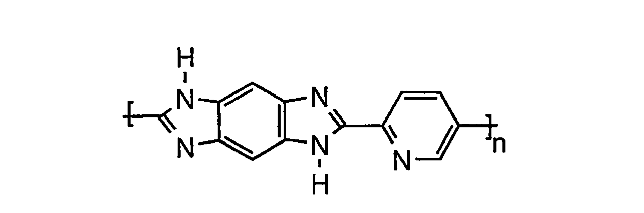 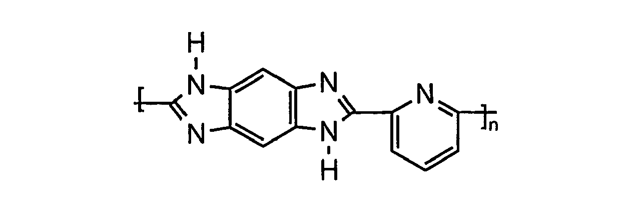 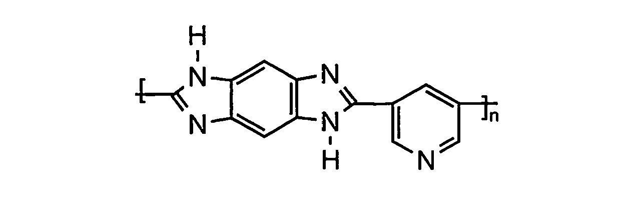 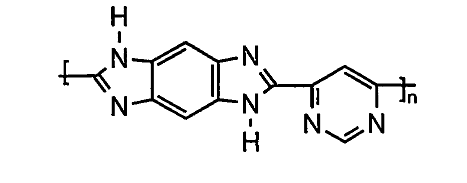 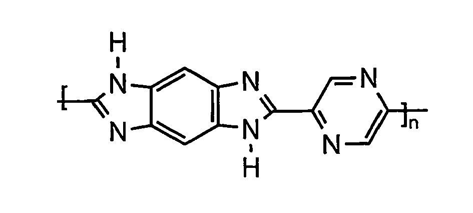 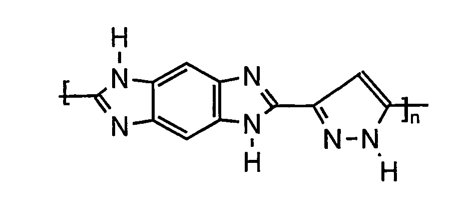 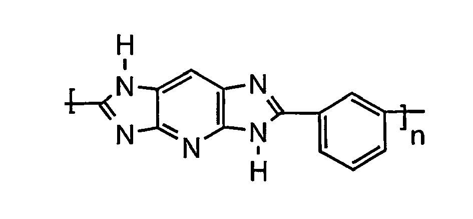 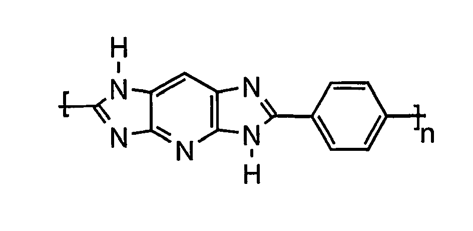 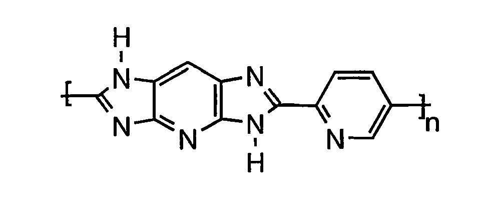 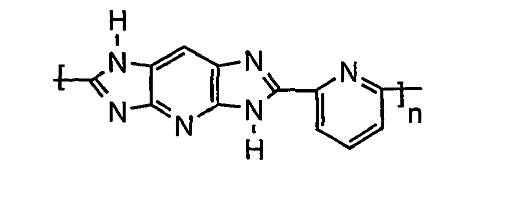 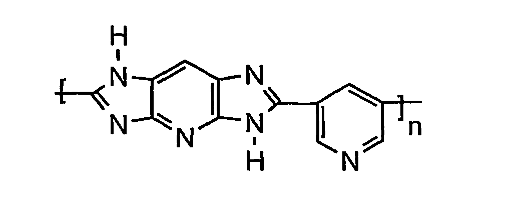 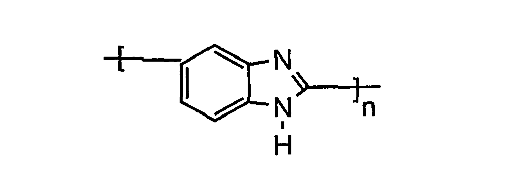 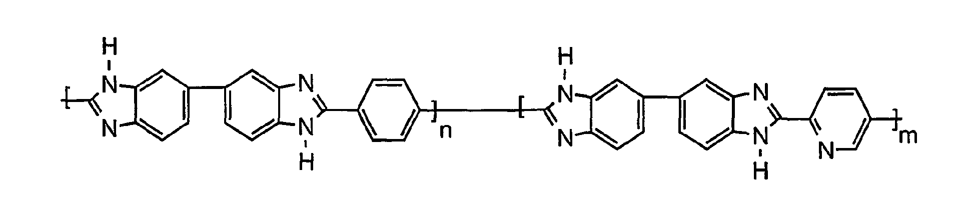 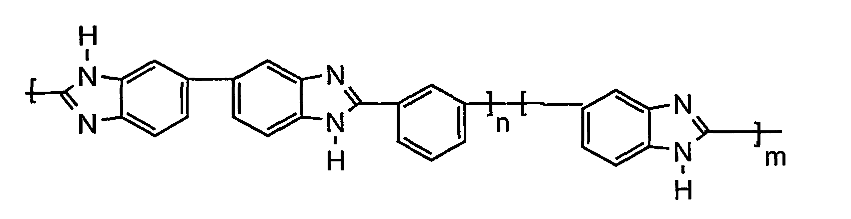 wobei n und m eine ganze Zahl größer gleich 10, vorzugsweise größer gleich 100 ist, handelt.

4. Verfahren zur Herstellung der Polymerfolie gemäß Anspruch 1 umfassend die Schritte
A) Aufbringen einer Lösung und/oder Suspension enthaltend Polyazol-Polymer in einem Lösungsmittel auf einen Träger, dessen Oberfläche in einer solchen Weise aufgerauht ist, das die erwünschte Rauhigkeit erhalten wird, unter Ausbildung einer flächigen Schicht,
B) Trocknung der gemäß Schritt A) gebildeten Schicht und
C) Ablösen der getrockneten Polymerfolie vom Träger.

5. Verfahren gemäß Anspruch 4, **dadurch gekennzeichnet, daß** als Lösungsmittel ein polares, aprotisches Lösungsmittel, insbesondere N,N-Dimethylacetamid, eingesetzt wird.

6. Verfahren gemäß Anspruch 4, **dadurch gekennzeichnet, daß** die in Schritt A) erzeugte Schicht eine Dicke zwischen 15 und 4000 µm aufweist.

7. Verfahren gemäß Anspruch 4, **dadurch gekennzeichnet, daß** in Schritt A) ein inerter Träger, vorzugsweise ein Metallband, eingesetzt wird.

8. Verfahren gemäß Anspruch 7, **dadurch gekennzeichnet, daß** der Träger eine Rauheit aufweist, welche die Rauheit der Polymermembran aufweist.

9. Verfahren gemäß Anspruch 4, **dadurch gekennzeichnet, daß** die Polymerfolie nach Schritt C) vernetzt wird.

10. Verfahren gemäß Anspruch 4, **dadurch gekennzeichnet, daß** in Schritt A) weitere Füllstoffe, insbesondere protonenleitende Füllstoffe, zugesetzt werden.

11. Verwendung der Polymerfolie gemäß Anspruch 1 als Filtermedium, insbesondere in der Gasfiltration und -trennung oder Gasaufreinigung, sowie in der Umkehr-Osmose, als Substrat in der Elektronikindustrie, insbesondere für flexible elektrische Schaltungen, gedruckte elektrische Schaltungen, in Transistoren, Kondensatoren und anderen elektronischen Bauteilen, als Batterieseparatoren, als Schutzfolie für elektrische Kabel, als Isolator in elektrischen Bauteilen und Vorrichtungen wie Kondensatoren, als Schutzfolie für Metall- und sonstige Oberflächen und zur Herstellung von Polymerelektrolytmembranen für elektrochemische Zellen, insbesondere für Brennstoffzellen- und Elektrolyseanwendungen, in Batteriesystemen und Kondensatoren.

12. Elektrochemische Zelle, die mindestens eine Polymermembran hergestellt aus einer Polymerfolie gemäß einem der Ansprüche 1 bis 3 und mindestens eine Elektrode aufweist.

13. Membran-Elektroden-Einheit, die mindestens eine Polymermembran hergestellt aus einer Polymerfolie gemäß einem der Ansprüche 1 bis 3 und mindestens eine Elektrode aufweist.

14. Membran-Elektroden-Einheit gemäß Anspruch 13, **dadurch gekennzeichnet, daß** die Polymermembran mit mindestens einer Lewis- und/oder Bronsted-Säuren, bevorzugt Schwefelsäure und/oder Phosphorsäure, insbesondere Phosphorsäure, dotiert ist.

15. Brennstoffzelle die mindestens eine Membran-Elektroden-Einheit gemäß Anspruch 13 aufweist.

## Claims

1. A polymer film based on polyazoles, which has a smooth and a rough side, whereby the roughness of the smooth side < 2 µm and the roughness of the rough side amounts to between 3 to 10 µm.

2. The polymer film according to claim 1, **characterized in that** it concerns a polyazole containing recurring azole units of the general formula (I) and/or (II) and/or (III) and/or (IV) and/or (V) and/or (VI) and/or (VII) and/or (VIII) and/or (IX) and/or (X) and/or (XI) and/or (XII) and/or (XIII) and/or (XIV) and/or (XV) and/or (XVI) and/or (XVI) and/or (XVII) and/or (XVIII) and/or (XIX) and/or (XX) and/or (XXI) and/or (XXII) 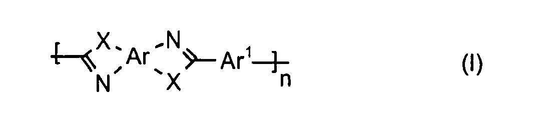 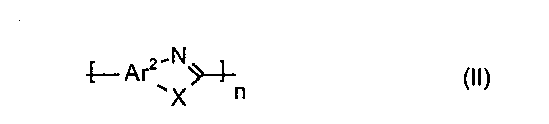 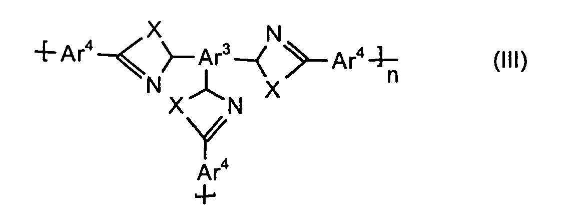 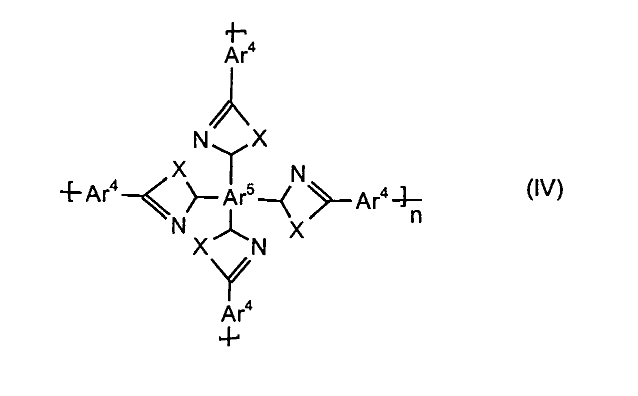 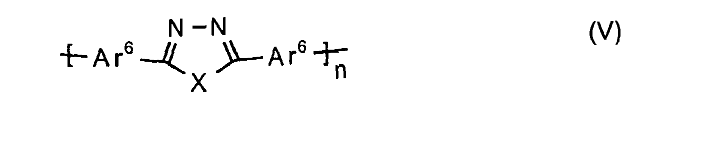 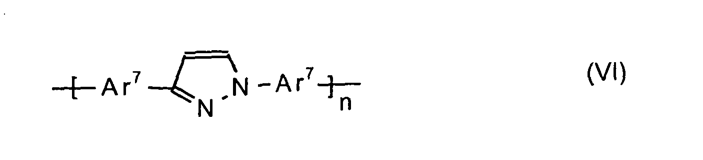 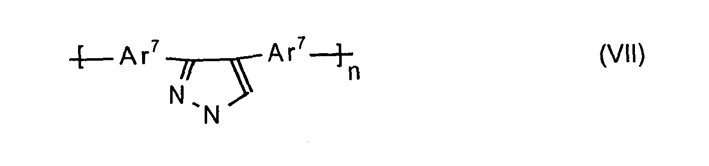 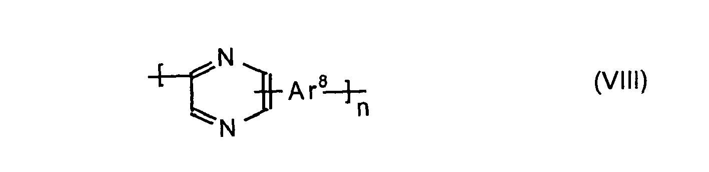 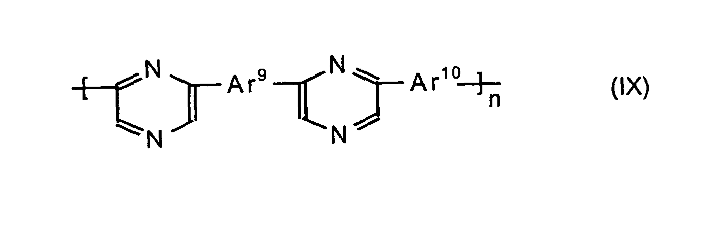 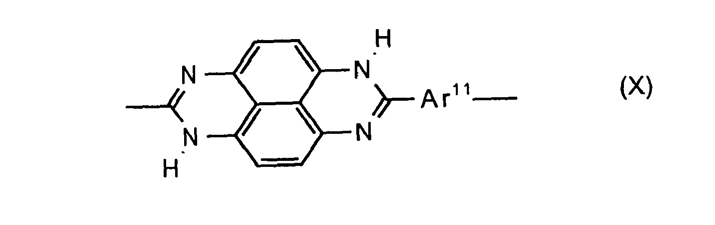 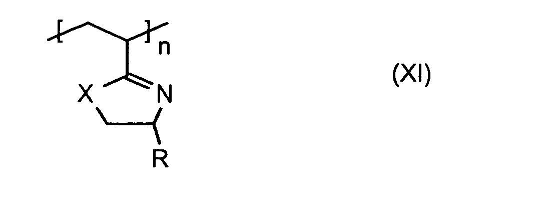 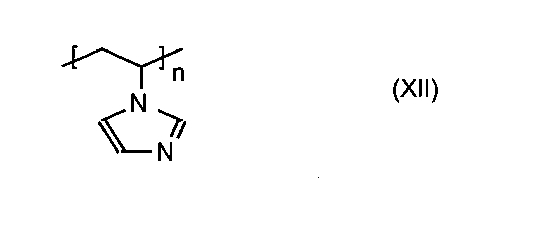 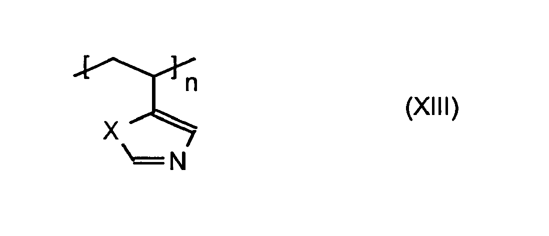 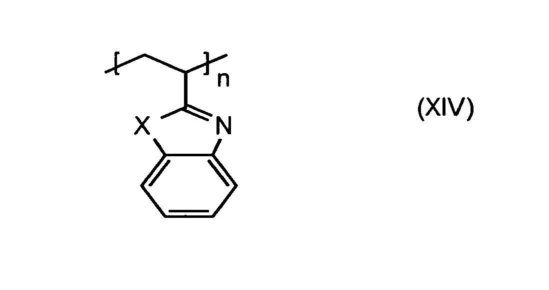 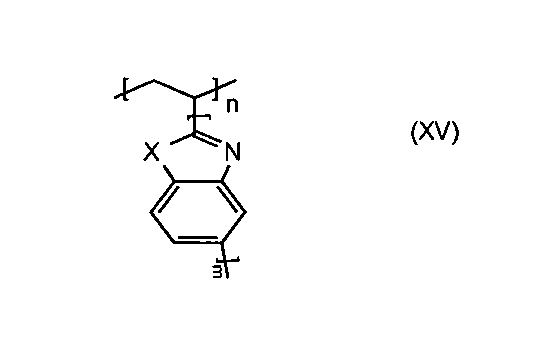 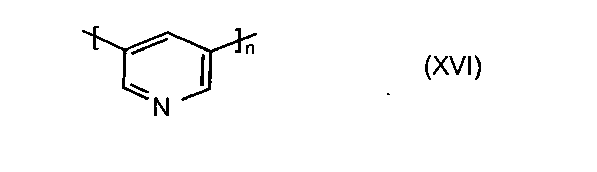 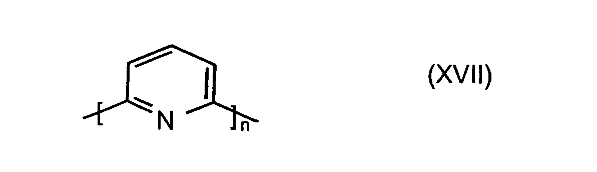 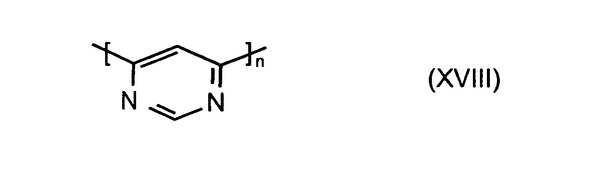 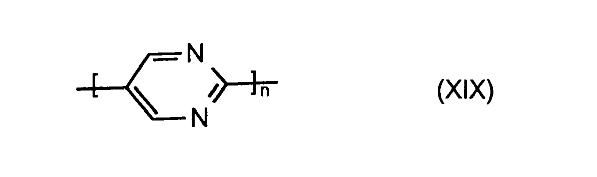 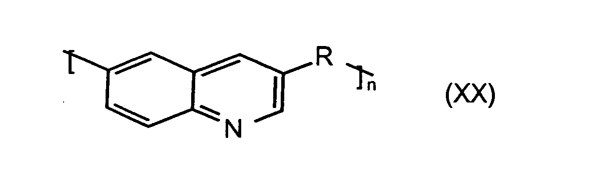 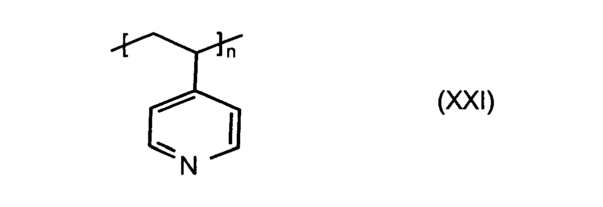 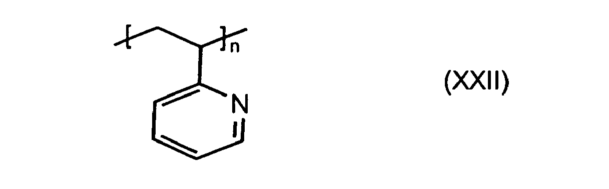 wherein
Ar are identical or different and stand for a tetravalent aromatic or heteroaromatic group, which can be mononuclear or polynuclear,
Ar¹ are indentical or different and stand for a bivalent aromatic or heteroaromatic group, which can be mononuclear or polynuclear,
Ar² are indentical or different and stand for a bivalent or trivalent aromatic or heteroaromatic group, which can be mononuclear or polynuclear,
Ar³ are indentical or different and stand for a trivalent aromatic or heteroaromatic group, which can be mononuclear or polynuclear,
Ar⁴ are indentical or different and stand for a trivalent aromatic or heteroaromatic group, which can be mononuclear or polynuclear,
Ar⁵ are indentical or different and stand for a tetravalent aromatic or heteroaromatic group, which can be mononuclear or polynuclear,
Ar⁶ are indentical or different and stand for a bivalent aromatic or heteroaromatic group, which can be mononuclear or polynuclear,
Ar⁷ are indentical or different and stand for a bivalent aromatic or heteroaromatic group, which can be mononuclear or polynuclear,
Ar⁸ are indentical or different and stand for a trivalent aromatic or heteroaromatic group, which can be mononuclear or polynuclear,
Ar⁹ are indentical or different and stand for a bivalent or trivalent or tetravalent aromatic or heteroaromatic group, which can be mononuclear or polynuclear,
Ar¹⁰ are indentical or different and stand for a bivalent or trivalent aromatic or heteroaromatic group, which can be mononuclear or polynuclear,
Ar¹¹ are indentical or different and stand for a bivalent aromatic or heteroaromatic group, which can be mononuclear or polynuclear,
X is identical or different and stands for oxygen, sulphur or an amino group, which carries a hydrogen atom, a group having 1- 20 carbon atoms, preferably a branched or unbranched alkyl or alkoxy group, or an aryl group as a further radical
R identical or different, stands for hydrogen, an alkyl group and an aromatic group, whereby radical R in formula (XX) is different from hydrogen, and
n, m is a whole number greater than or equal to 10, preferably greater than or equal to 100.

3. The polymer film according to claim 1, **characterised in that** it concerns a polyazole containing recurring azole units of the general formula 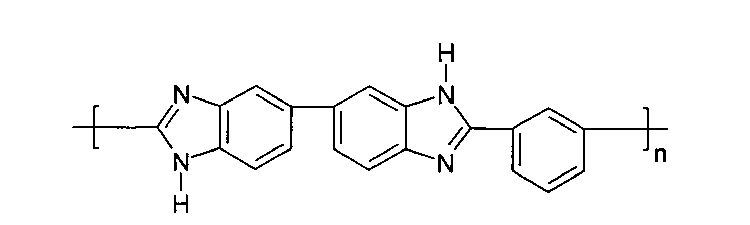 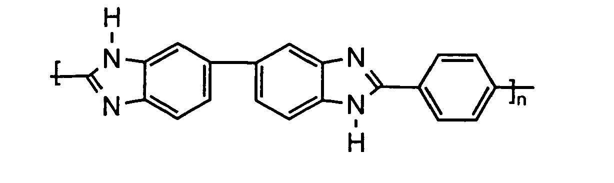 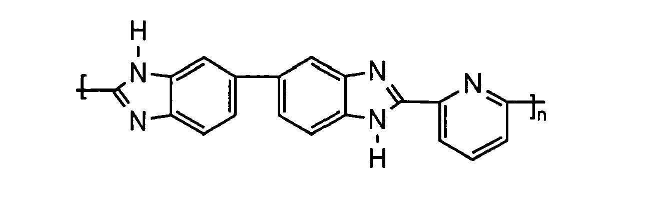 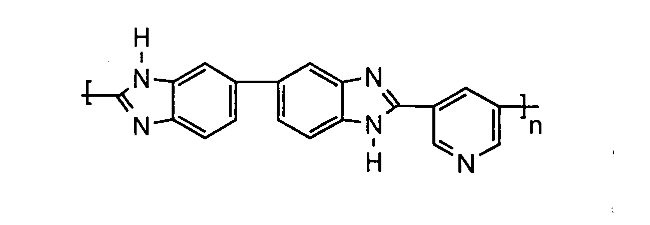 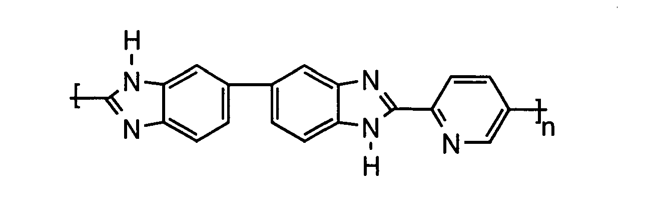 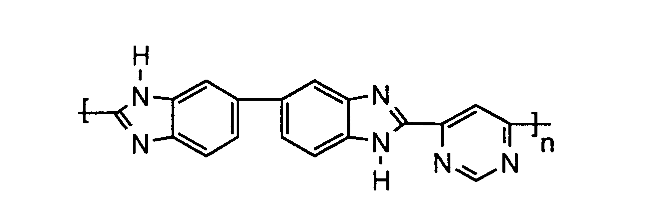 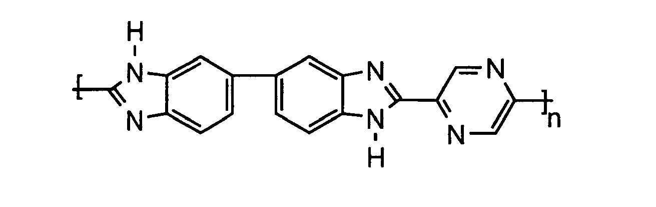 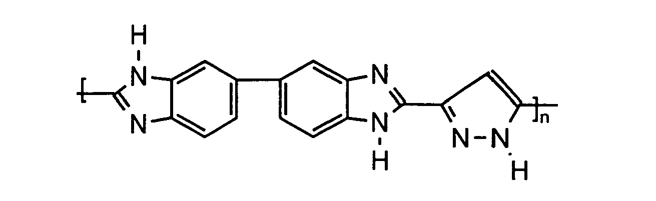 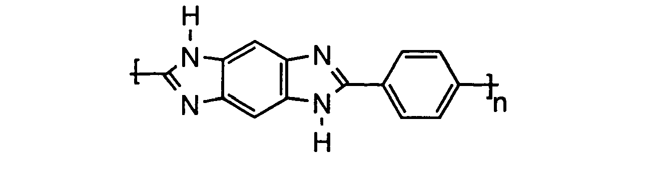 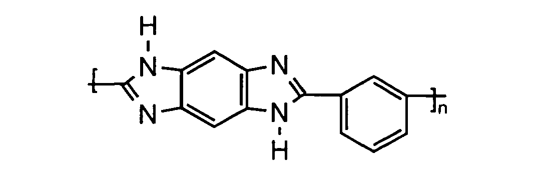 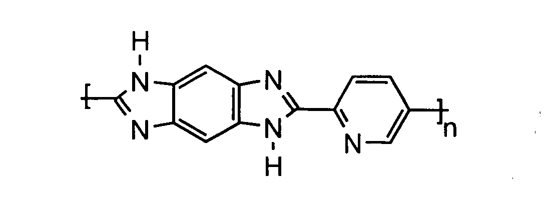 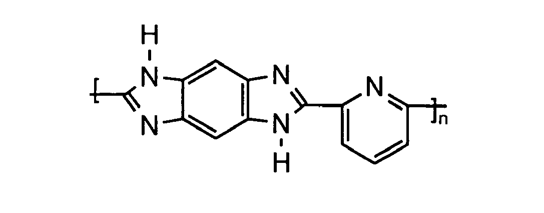 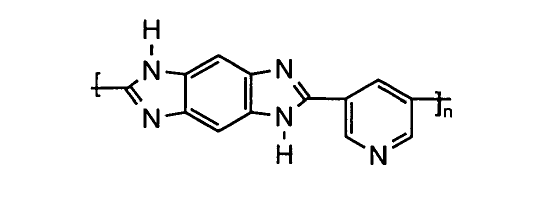 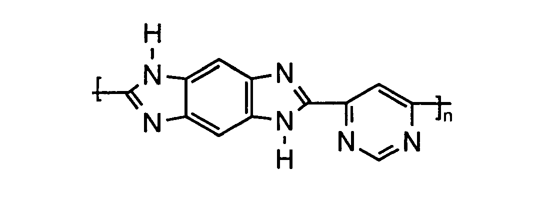 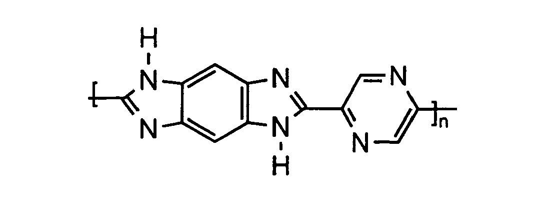 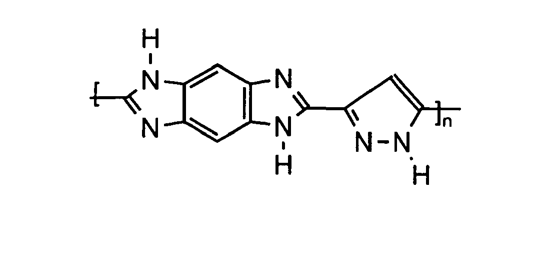 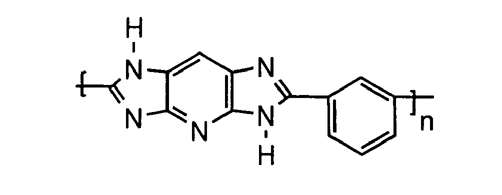 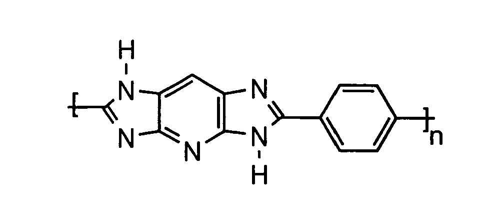 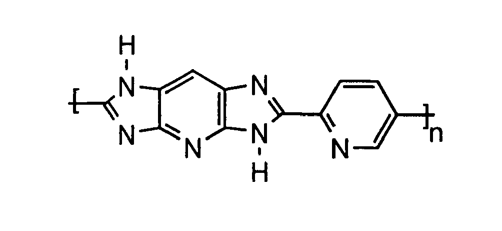 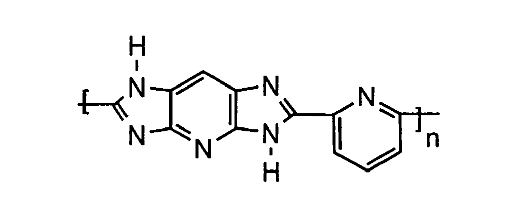 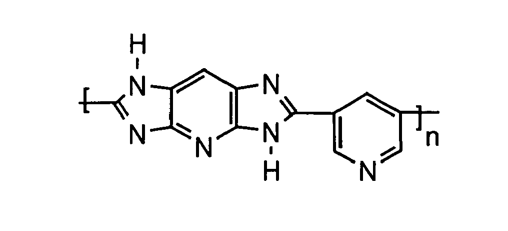 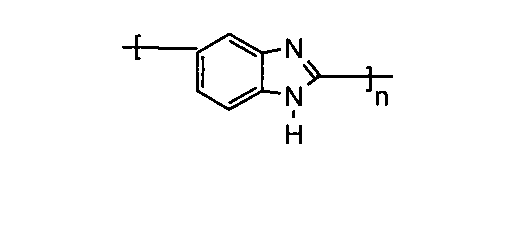 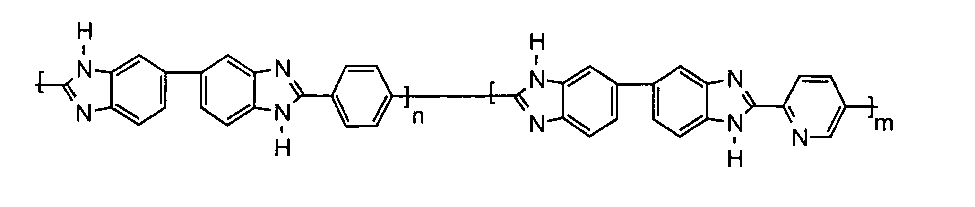 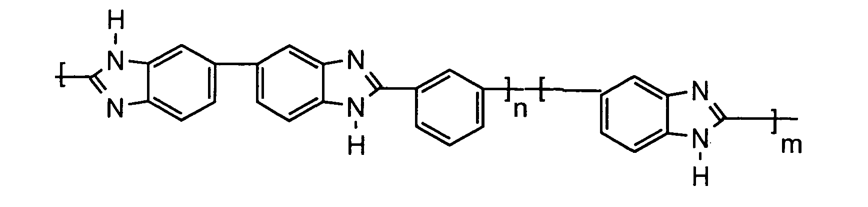 where n and m is a whole number greater than or equal to 10, preferably greater than or equal to 100.

4. A method for the production of the polymer film according to claim 1 comprising the steps
A) deposition of a solution and/or suspension containing polyazole polymer in a solvent on a carrier, the surface whereof is roughened in such a way that the desired roughness is obtained, with the formation of a two-dimensional layer,
B) drying of the layer formed according to step A) and
C) detachment of the dried polymer film from the carrier.

5. The method according to claim 4, **characterised in that** a polar, aprotic solvent, in particular N,N-dimethylacetamide, is used as a solvent.

6. The method according to claim 4, **characterised in that** the layer produced in step A) has a thickness between 15 and 4000 µm.

7. The method according to claim 4, **characterised in that** an inert carrier, preferably a metal strip, is used in step A).

8. The method according to claim 7, **characterised in that** the carrier has a roughness which has the roughness of the polymer membrane.

9. The method according to claim 4, **characterised in that** the polymer film is cross-linked after step C).

10. The method according to claim 4, **characterised in that** further fillers, in particular proton-conducting fillers, are added in step A).

11. Use of the polymer film according to claim 1 as a filler medium, in particular in gas filtration and separation or gas purification, as well as in reverse osmosis, as a substrate in the electronics industry, especially for flexible electric circuits, printed electric circuits, in transistors, capacitors and other electronic components, as battery separators, as protective film for electric cables, as insulators in electrical components and devices such as capacitors, as protective film for metal surfaces and other surfaces and for the production of polymer electrolyte membranes for electrochemical cells, in particular for fuel cells and electrolysis applications, in battery systems and capacitors.

12. An electrochemical cell, which has at least one polymer membrane produced from a polymer film according to any one of claims 1 to 3 and at least one electrode.

13. A membrane electrode unit which has at least one polymer membrane produced from a polymer film according to any one of claims 1 to 3 and at least one electrode.

14. The membrane electrode unit according to claim 13, **characterised in that** the polymer membrane is doped with at least one Lewis and/or Bronsted acid, preferably sulphuric acid and/or phosphoric acid, in particular phosphoric acid.

15. A fuel cell which has at least one membrane electrode unit according to claim 13.

## Revendications

1. Feuille de polymère se basant sur les polyazoles, qui présente une face lisse et l'une rugueuse, où la rugosité de la face lisse comprend < 2 µm et la rugosité de la face rugueuse entre 3 et 10 µm.

2. Feuille de polymère selon la revendication 1, **caractérisée en ce qu'**il s'agit d'un polyazol contenant des unités azoliques répétées avec la formule générale (I) et/ou (II) et/ou (III) et/ou (IV) et/ou (V) et/ou (VI) et/ou (VII) et/ou (VIII) et/ou (IX) et/ou (X) et/ou (XI) et/ou (XII) et/ou (XIII) et/ou (XIV) et/ou (XV) et/ou (XVI) et/ou (XVI) et/ou (XVII) et/ou (XVIII) et/ou (XIX) et/ou (XX) et/ou (XXI) et/ou (XXII). 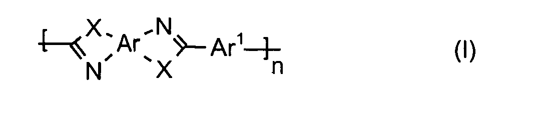 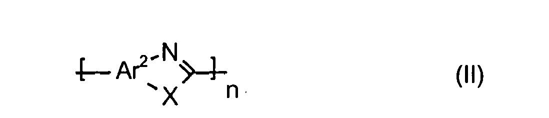 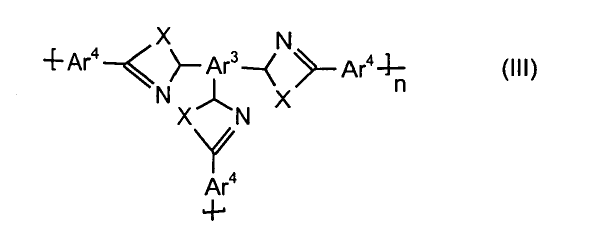 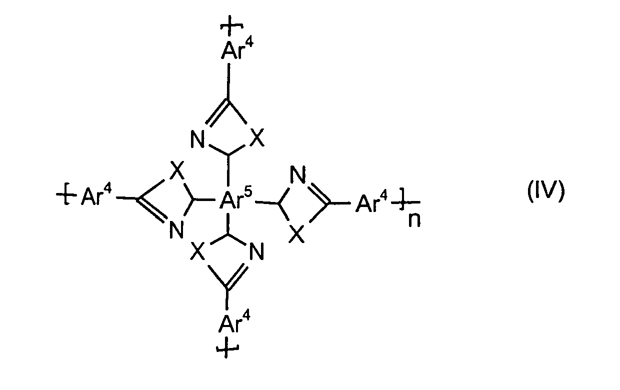 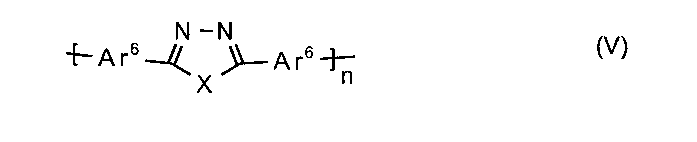 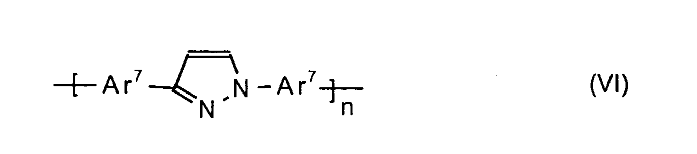 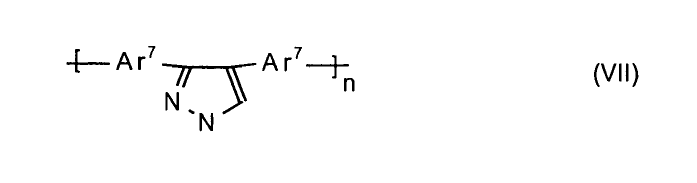 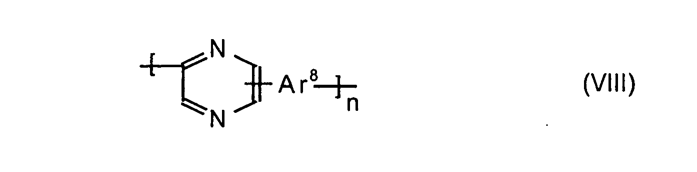 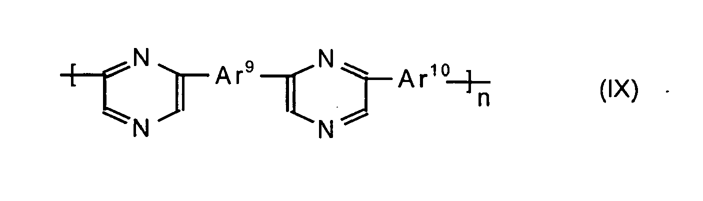 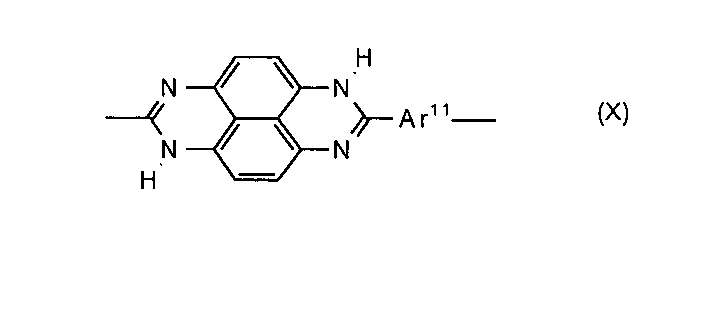 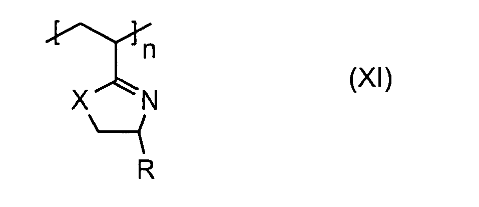 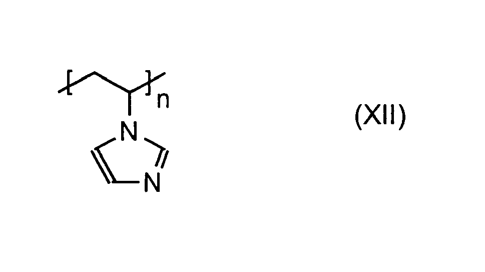 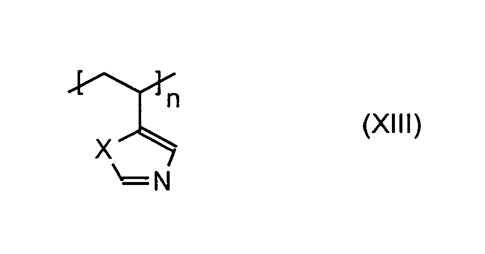 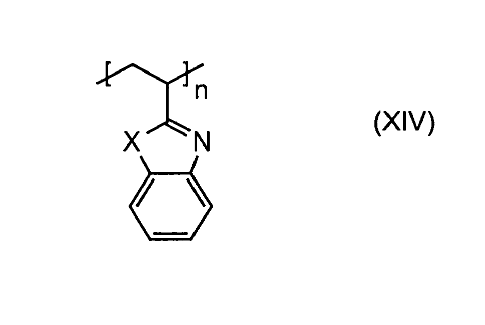 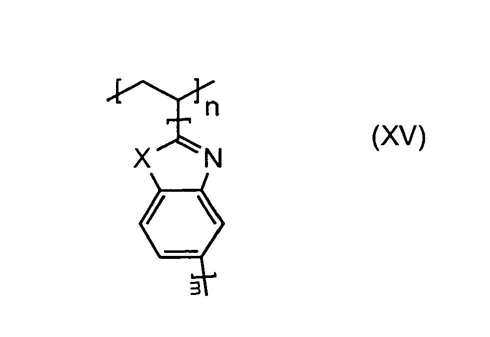 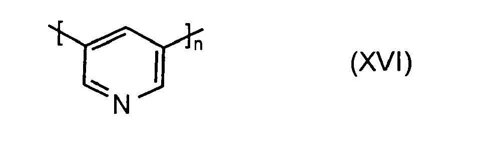 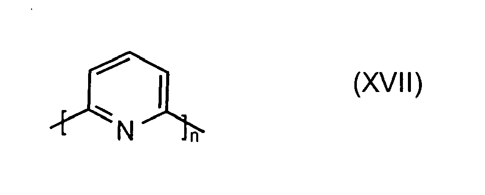 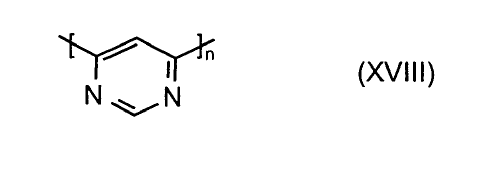 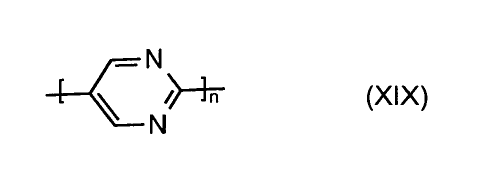 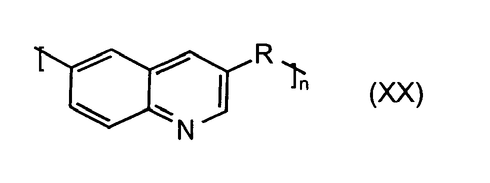 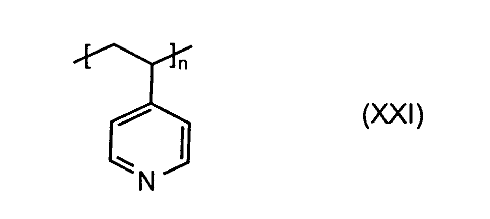 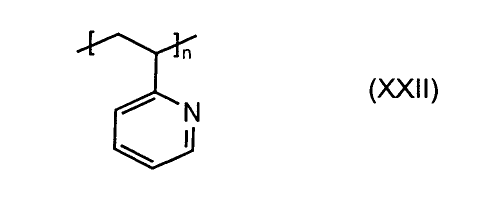 où:
Ar sont identiques ou différentes aussi pour un groupement aromatique ou hétéroaromatique tétravalent, qui peut être mono- ou polynucléaire.
Ar¹ sont identiques ou différentes aussi pour un groupement aromatique ou hétéroaromatique bivalent, qui peut être mono- ou polynucléaire.
Ar² sont identiques ou différentes aussi pour un groupement aromatique ou hétéroaromatique bi- ou trivalent, qui peut être mono- ou polynucléaire.
Ar³ sont identiques ou différentes aussi pour un groupement aromatique ou hétéroaromatique trivalent, qui peut être mono- ou polynucléaire.
Ar⁴ sont identiques ou différentes aussi pour un groupement aromatique ou hétéroaromatique trivalent, qui peut être mono- ou polynucléaire.
Ar⁵ sont identiques ou différentes aussi pour un groupement aromatique ou hétéroaromatique tétravalent, qui peut être mono- ou polynucléaire.
Ar⁶ sont identiques ou différentes aussi pour un groupement aromatique ou hétéroaromatique bivalent, qui peut être mono- ou polynucléaire.
Ar⁷ sont identiques ou différentes aussi pour un groupement aromatique ou hétéroaromatique bivalent, qui peut être mono- ou polynucléaire.
Ar⁸ sont identiques ou différentes aussi pour un groupement aromatique ou hétéroaromatique trivalent, qui peut être mono- ou polynucléaire.
Ar⁹ sont identiques ou différentes aussi pour un groupement aromatique ou hétéroaromatique bi- ou tri- ou tétravalent, qui peut être mono- ou polynucléaire.
Ar¹⁰ sont identiques ou différentes aussi pour un groupement aromatique ou hétéroaromatique bi- ou trivalent, qui peut être mono- ou polynucléaire.
Ar¹¹ sont identiques ou différentes aussi pour un groupement aromatique ou hétéroaromatique bivalent, qui peut être mono- ou polynucléaire.
X est identique ou différent aussi pour oxygène, soufre ou un groupement amino, qui porte comme autre reste un atome d'hydrogène, un groupement qui présente 1-20 atomes de carbone, de préférence un groupement alkyle- ou alcoxy ramifié ou non ramifié ou un groupement aryle.
R identique ou différent pour hydrogène, un groupement alkyle et un groupement aromatique, où le reste R de la formule (XX) est différent de l'hydrogène, et
n, m un nombre entier plus ou égal à 10, préférablement plus de 100.

3. Feuille de polymère selon la revendication 1, **caractérisée en ce qu'**il s'agit d'un polyazol contenant des unités azoliques répétées avec la formule générale 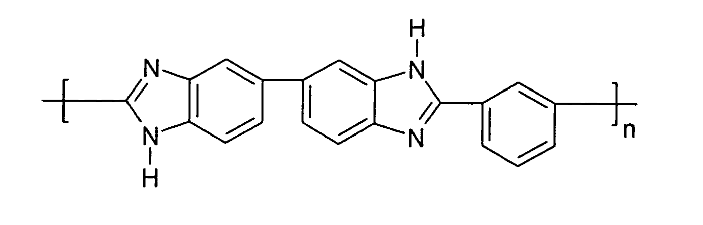 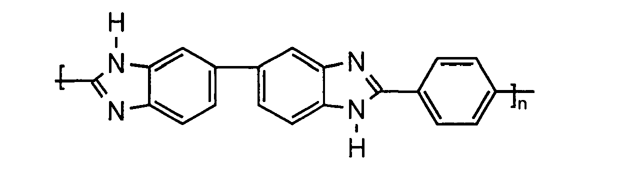 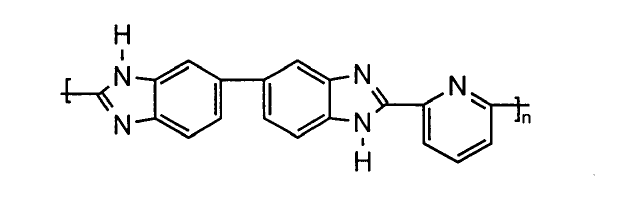 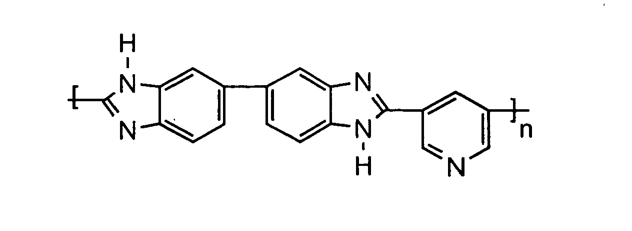 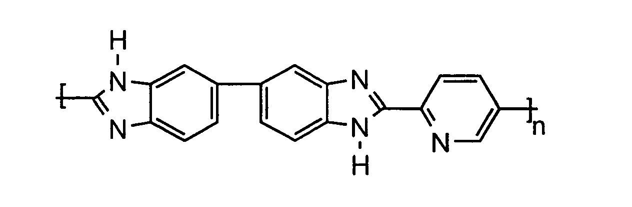 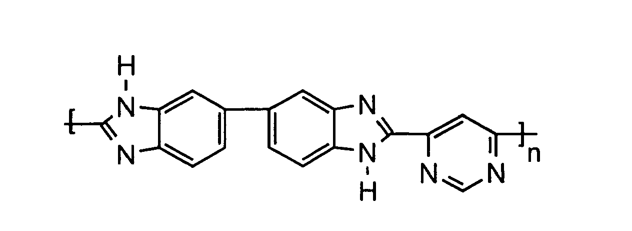 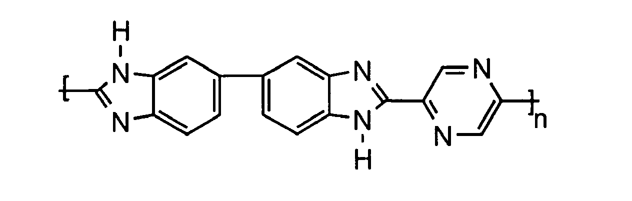 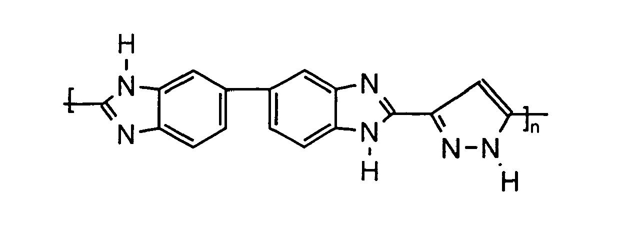 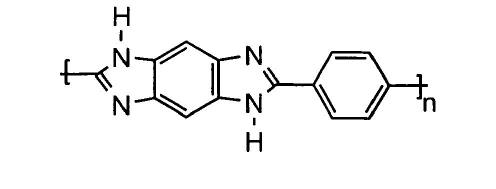 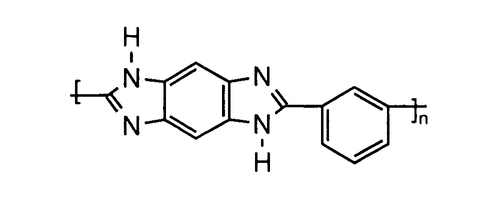 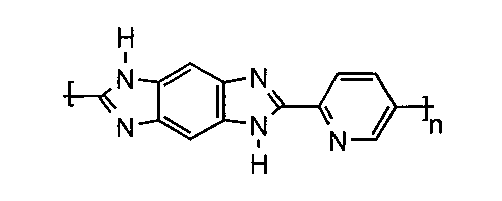 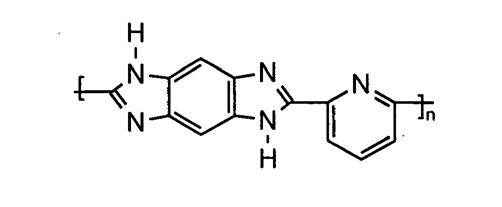 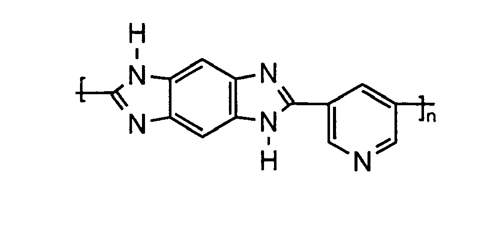 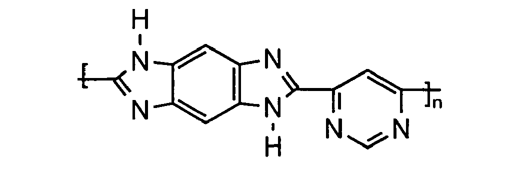 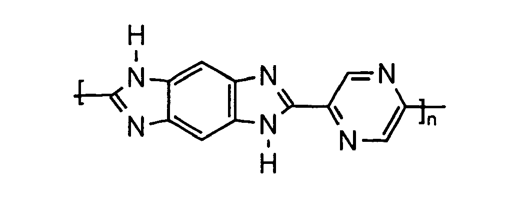 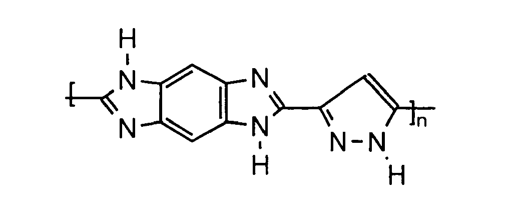 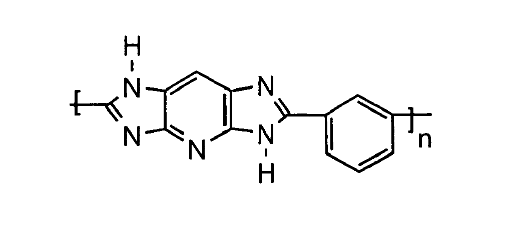 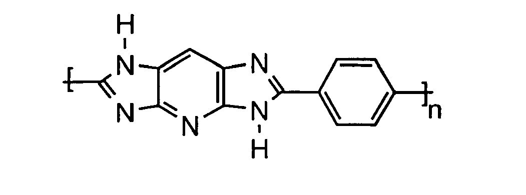 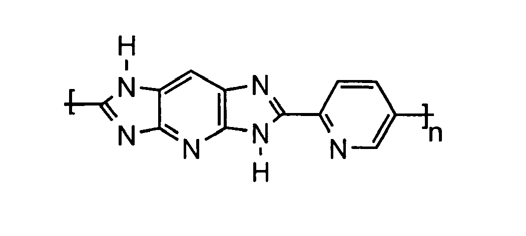 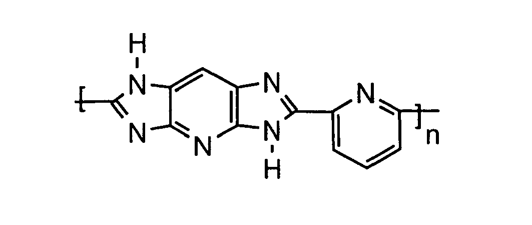 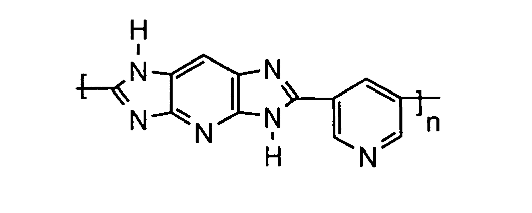 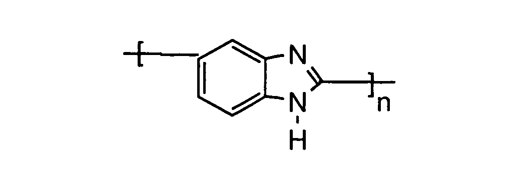 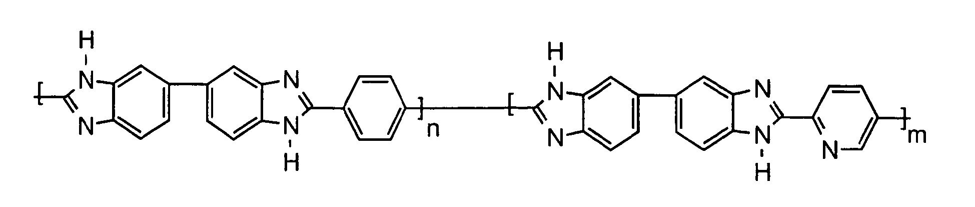 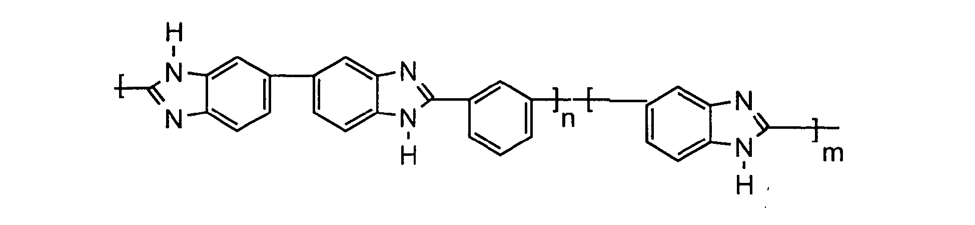 où n et m est un nombre entier plus ou égal à 10, préférablement plus de 100.

4. Procédé pour la production de la feuille de polymère selon la revendication 1 comprenant les étapes:
A) Application d'une solution et/ou d'une suspension contenant du polymère polyazolique sur un porteur dont la surface est rendue rude d'une telle manière, qu'on obtient la rugosité désirée, avec la formation d'une couche étendue,
B) Séchage de la couche formée conforme à l'étape A) et
C) Eloignement de la feuille de polymère séchée du porteur.

5. Procédé selon la revendication 4, **caractérisé en ce qu'**on utilise comme solvant un solvant polaire, aprotique, spécialement le N, N-diméthylacétamide.

6. Procédé selon la revendication 4, **caractérisé en ce que**, la couche produite dans l'étape A) présente une épaisseur entre 15 et 4000 µm.

7. Procédé selon la revendication 4, **caractérisé en ce que** dans l'étape A) s'utilise un porteur inerte, de préférence une bande de métal.

8. Procédé selon la revendication 7, **caractérisé en ce que** le porteur présente une rugosité, qui représente la rugosité de la membrane de polymère.

9. Procédé selon la revendication 4, **caractérisé en ce que**, la feuille de polymère sera réticulée après l'étape C).

10. Procédé selon la revendication 4, **caractérisé en ce que** dans l'étape A) on ajoute d'autres substances de remplissage, spécialement des substances de remplissage conductrices de protons.

11. Utilisation de feuille de polymère selon la revendication 1 comme matériau filtrant, spécialement dans la filtration et la séparation des gaz ou à la purification des gaz, aussi bien que dans l'osmose inverse, comme substrat dans l'industrie électronique, spécialement pour les connexions électriques flexibles, les connexions électriques imprimées, dans les transistors, les condenseurs et d'autres composants électroniques, comme des séparateurs de batterie, comme feuille protectrice pour les câbles électriques, comme isolateur dans les composants électriques et les dispositifs comme seraient les condenseurs, comme feuille protectrice pour les surfaces métalliques et d'autre sorte et pour la production des membranes à électrolyte polymérique pour les cellules électrochimiques, spécialement pour des applications dans les cellules de combustion et d'électrolyse, dans les systèmes de batteries et de condenseurs.

12. Cellules électrochimiques qui présentent au moins une membrane de polymère produite d'une feuille de polymère selon l'une d'entre les revendications 1 à 3 et au moins une électrode.

13. Unité membrane-électrode qui présente au moins une membrane de polymère produite d'une feuille de polymère selon l'une d'entre les revendications 1 à 3 et au moins une électrode.

14. Unité membrane-électrode selon la revendication 13, **caractérisée en ce que** la membrane de polymère est dopée avec au moins un acide Lewis et/ou Bronsted, de préférence l'acide sulfurique et/ou l'acide phosphorique, spécialement l'acide phosphorique.

15. Cellule de combustion qui présente au moins une unité membrane-électrode selon la revendication 13.
